Europäisches Patentamt

European Patent Office

Office européen des brevets

(19)

(11) EP 0 770 926 A2

(12) **EUROPEAN PATENT APPLICATION**

(43) Date of publication:
02.05.1997 Bulletin 1997/18

(51) Int Cl.⁶: **G03F 7/20**, G03F 1/00

(21) Application number: 96302314.8

(22) Date of filing: 01.04.1996

(84) Designated Contracting States:
DE FR GB IT NL

(30) Priority: 19.09.1995 KR 9530677

(71) Applicant: **Samsung Electronics Co., Ltd.**
Suwon-city, Kyungki-do 441-370 (KR)

(72) Inventors:
• **Lee, Jung-hyun**
Suwon-city, Kyungki-do (KR)

• **Han, Woo-sung**
Suwon-city, Kyungki-do (KR)
• **Moon, Sung-Yong**
Uiwang-city, Kyungki-do (KR)
• **Sohn, Chang-jin**
Songtan-city, Kyungki-do (KR)

(74) Representative: **Crawford, Fiona Merle et al**
**Elkington and Fife**
**Prospect House**
**8 Pembroke Road**
**Sevenoaks, Kent TN13 1XR (GB)**

(54) **Method for forming fine pattern of semiconductor device**

(57) A new method for forming optically a fine pattern of a semiconductor device is provided. Dummy lines or dummy spaces below the resolution limit of the optical source are added to a main pattern on a mask for defining the exposure area of an object to be exposed. A fine pattern of a desired size can be formed with improved resolution.

# FIG. 8A

DUMMY SPACE

CONTACT HOLE

EP 0 770 926 A2

# FIG. 8C

DUMMY SPACE

CONTACT HOLE

## Description

The present invention relates to a method for manufacturing a semiconductor device, and, more particularly, to a method for forming a fine pattern of a semiconductor device which can improve resolution.

To obtain a contact hole of a size suitable for 64Mb DRAMs and beyond, the resolution limits of the current i-line (365nm) and deep-ultraviolet (248nm) of an imaging system are required. 0.42μm and 0.3μm contact holes can be resolved with the i-line and the deep-ultraviolet, respectively, when a photoresist is used. Such results are obtained with conventional masks.

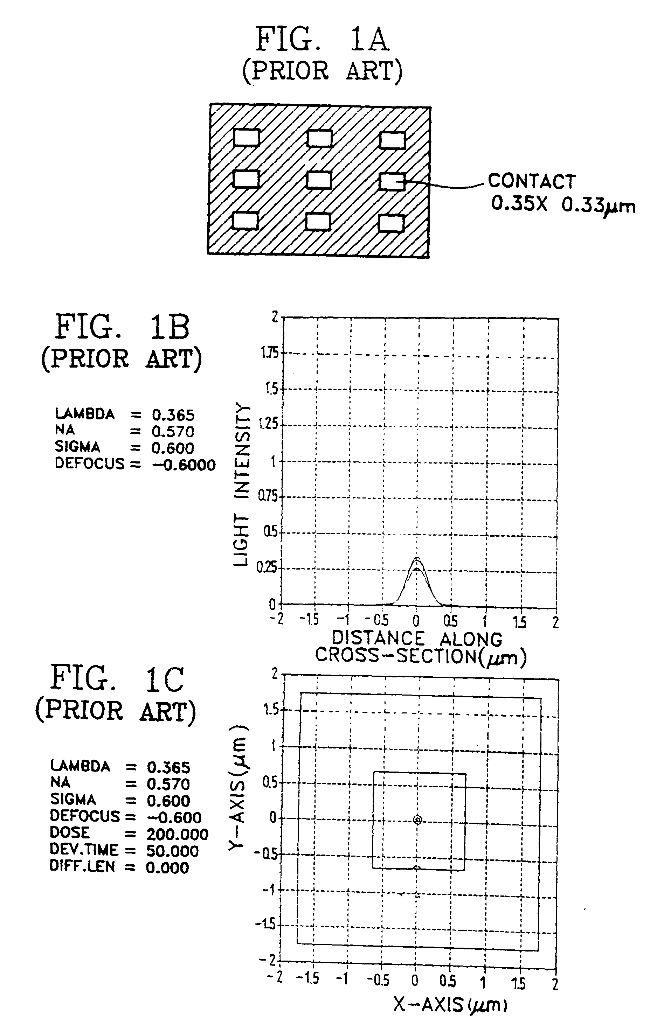

FIGS. 1A, 1B and 1C are a layout view of patterns, a profile of light intensity, and a photoresist profile, respectively, when a conventional i-line chromium (Cr) mask is used. A simulation is performed with an i-line (365nm), an NA (numerical aperture) of 0.57, and a coherency of 0.6. In FIG. 1C, a 0.35μm×0.33μm contact hole which is 0.1μm smaller than the minimum size resolvable with the i-line, is not opened in a simulation performed by a simulation tool.

Therefore, to increase image resolution of a mask, a Levenson phase shift mask is used. The Levenson mask relies on a phase-shift which enables exposure of a pattern of a desired size by utilizing light interference or partial light interference. A half-tone phase shift mask utilizes the principle that the transmissivity of a light-shielding portion is greater than zero and the other portion is phase-shifted, such that image definition is enhanced by destructive interference between light diffracted in the two adjacent transmitting zones. With these masks, sizes of 0.34μm and 0.26μm are resolvable in a photoresist with the i-line and the deep-ultraviolet respectively, but the masks are difficult to manufacture.

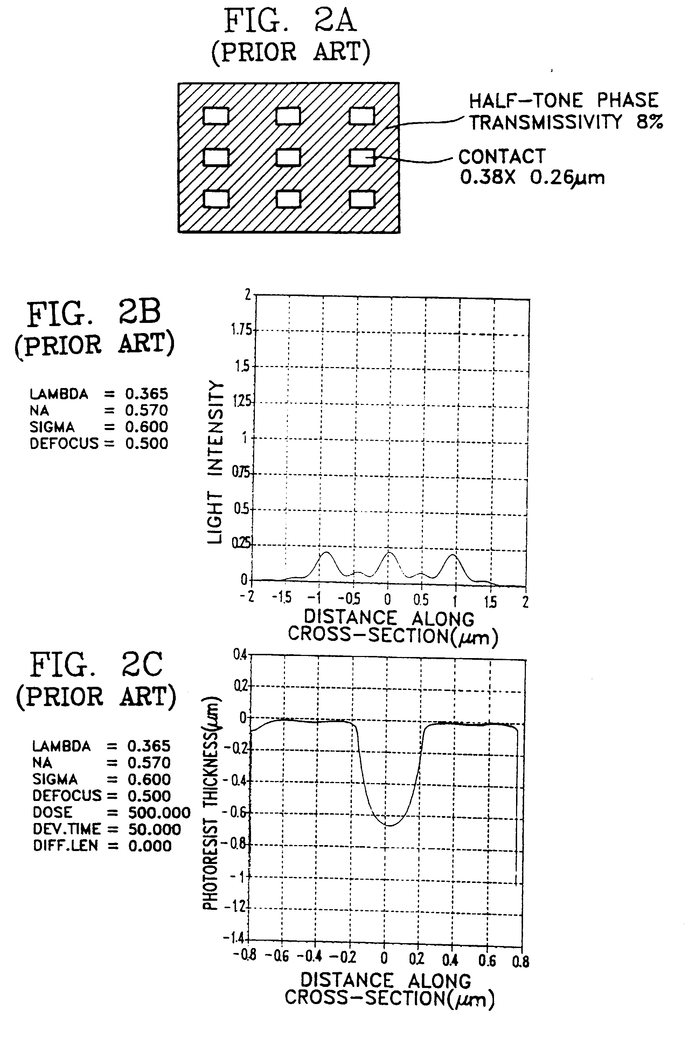

FIGS. 2A, 2B and 2C are, respectively, a layout view of patterns, a profile of light intensity, and a profile of a photoresist when a conventional half-tone phase shift mask is used. The transmissivity of the light blocking portion is 8% and the phase shift is 180° in the half-tone phase shift mask. A simulation is then performed with the following conditions: an i-line (365nm), an NA of 0.57, and a coherency of 0.6. A 0.38μmx0.26μm contact hole is simulated. In the simulation, the light intensity is weak and, using a commercially available photoresist, the contact hole is not opened.

Furthermore, in lithography of a semiconductor device, most methods for increasing the resolution of patterns are dedicated to pairs of line/space (L/S) patterns. For contact hole patterns, there are only provided a rim-type phase shift mask, with which by forming shifters around all L/S patterns only the edge of a pattern is improved, a half-tone phase shift mask, and a serif contact forming method. Therefore, a contact hole layer is known to be the most difficult in which to enhance the image definition.

In general, resolution (R) is proportional to the wavelength (λ) of a light source, and inversely proportional to the NA of a stepper.

$$R = k_1\left(\frac{\lambda}{NA}\right) \qquad \qquad ...(1)$$

where $k_1$ is a constant dependent on the process. However, since $k_1$ is proportional to R, and so it must be small to obtain a small R value, great efforts are expended to making $k_1$ small. Here, the value of $k_1$ can be reduced through the improvement of the photoresist or the associated process, or by optimizing a mask pattern.

As described above, $k_1$ is generally smaller in an L/S pair than in a contact hole (for example, 0.55 for the L/S pair and 0.65 for the contact hole). Improvement for L/S pairs is easier than for contact holes. Thus, although the same design rule is applied to an L/S pair and a contact hole at the stage of designing devices, the contact hole is always printed to be larger on a wafer than the L/S pair, thus decreasing the layer-to-layer overlay tolerance.

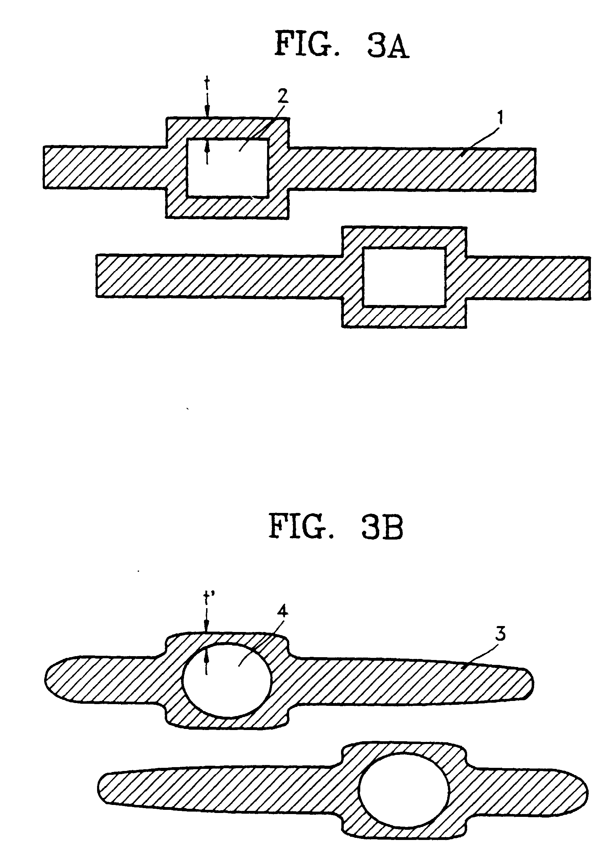

FIGS. 3A and 3B illustrate layer-to-layer overlay tolerances. FIG. 3A is a layout view of patterns in a computer-aided design, and FIG. 3B illustrates a photoresist image on a wafer.

Referring to FIGS. 3A and 3B, if there is a contact hole 2 over or below an L/S pattern 1, an overlay tolerance t is given in the design. When these patterns are transferred onto the wafer by a stepper into a L/S pattern 3 and a contact hole 4 on a photoresist, all the corners of the L/S are rounded and the rectangular contact hole in the design becomes larger and rounded. Therefore, the overlay tolerance is actually reduced to t'.

An object of the present invention is to provide a method for forming a fine pattern of a semiconductor device which can increase resolution, by using resolution enhancement with extremely small dummy lines.

To achieve the above object, there is provided a method for optically forming a fine pattern of a semiconductor device, which can improve resolution by adding a dummy pattern below a resolution limit of the imaging system to a main pattern on a mask.

It is desirable to determine the size of the dummy pattern according to the size of a desired final fine pattern.

Preferably, the main pattern and the dummy pattern are of the same tone.

A half-tone phase shift mask may be used as the mask. The dummy pattern is preferably less than or equal to 0.42µm and 0.3µm when the i-line and the deep ultraviolet are used as a light source, respectively, a size that can avoid exposure of the light source.

Preferably, the main pattern of the mask is polygonal. A fine pattern is formed by using a curved pattern into which the polygonal main pattern is transferred onto the mask.

The dummy patterns of the main pattern are formed in one direction or in a cross pattern. Further, the dummy patterns may be formed to connect all the sides of the main patterns.

The dummy pattern is constituted by at least one pair.

The pair of dummy patterns may be formed symmetrical with respect to the main pattern. Preferably, the pair of dummy patterns are arranged in a cross pattern, centering on the main pattern.

Each of the pair of dummy patterns may be formed at the waist of the main pattern. Each dummy pattern is preferably formed at the waist of the main pattern, to be inclined with respect to the main pattern. It is preferable that the dummy pattern is inclined at an angle range of 0-180° with respect to the longitudinal axis of the main pattern. More preferably, the dummy pattern is inclined at 90° with the main pattern.

It is preferable that the dummy patterns are formed close to the main pattern or apart from the main pattern by a predetermined distance.

According to the present invention, an optical proximity effect is corrected and resolution is improved by forming a dummy pattern of a line or space of the resolution limit or below to a main pattern on a mask.

Specific embodiments of the present invention are described in detail below, by way of example, with reference to the attached drawings, in which:

FIGS. 1A, 1B and 1C are, respectively, a pattern layout view, a light intensity profile and a photoresist profile, when a conventional i-line mask is used;

FIGS. 2A, 2B and 2C are, respectively, a pattern layout view, a light intensity profile and a photoresist profile when a conventional half-tone phase shift mask is used;

FIGS. 3A and 3B illustrate layer-to-layer overlay tolerances when a contact hole is formed beside a line/space pattern;

FIGS. 4A, 4B and 4C are, respectively, a pattern layout view, a light intensity profile and a photoresist profile when an i-line mask according to a first embodiment of the present invention is used;

FIGS. 5A & 5B and FIGS. 5A' & 5B' are, respectively, a conventional deep-ultraviolet mask, a profile of light intensity thereof, a deep-ultraviolet mask according to the first embodiment of the present invention, and a profile of light intensity thereof;

FIGS. 6A, 6B and 6C are, respectively, a pattern layout view, a light intensity profile and a photoresist profile when a half-tone phase shift mask according to a second embodiment of the present invention is used;

FIGS. 7A and 7B illustrate changes of a contact hole according to the energy of a light source;

FIGS. 8A, 8B and 8C are views for explaining methods for forming dummy spaces on the half-tone phase shift mask, according to the second embodiment of the present invention;

FIGS. 9A-9C through 11A-11C are, respectively, pattern layout views, light intensity profiles in aerial images and photoresist profiles when a conventional mask, the conventional half-tone phase shift mask, and a mask according to a third embodiment of the present invention are used;

FIGS. 12-15 illustrate results simulated for conventional mask patterns and for those according to the third embodiment of the present invention;

FIGS. 16A, 16B and 16C are, respectively, a pattern layout view, a light intensity profile in an aerial image and a photoresist profile when a mask according to a fourth embodiment of the present invention is used;

FIGS. 17A-17C and 17D-17F compare characteristics of the conventional half-tone phase shift mask and of a mask according to the second embodiment of the present invention;

FIGS. 18A-18C and 18D-18F illustrate results simulated for patterns of the conventional i-line mask and for patterns of a mask according to the first embodiment of the present invention;

FIGS. 19A & 19B and 19C & 19D illustrate results simulated for patterns of the conventional deep-ultraviolet mask and for patterns of a mask according to the first embodiment of the present invention;

FIGS. 20A-20C and 20A'-20C' each illustrate pattern layouts and photoresist profiles of a mask according to a fifth embodiment of the present invention;

FIGS. 21A & 21B and FIGS. 21A'& 21B' each illustrate pattern layouts and photoresist profiles of a mask according to a sixth embodiment of the present invention;

FIGS. 22A & 22B and 22A'& 22B' each illustrate pattern layouts and photoresist profiles of a mask according to a seventh embodiment of the present invention;

FIGS. 23-26 illustrate results simulated for conventional mask patterns and for those of a mask according to the seventh embodiment of the present invention;

FIG. 27 illustrates a conventional mask pattern and mask pattern layouts;

FIGS. 28-31 illustrate mask patterns according to the third through sixth embodiments and mask pattern layouts;

FIGS. 32A and FIGS. 32B-32D are photographs of actual mask patterns according to a conventional method and actual mask patterns according to embodiments of the present invention;

FIGS. 33, 34 and 35 each illustrate mask patterns according to the seventh embodiment of the present invention and mask pattern layouts; and

FIGS. 36-44 and 45A-45C each illustrate mask patterns and mask pattern layouts, according to the first through seventh embodiments.

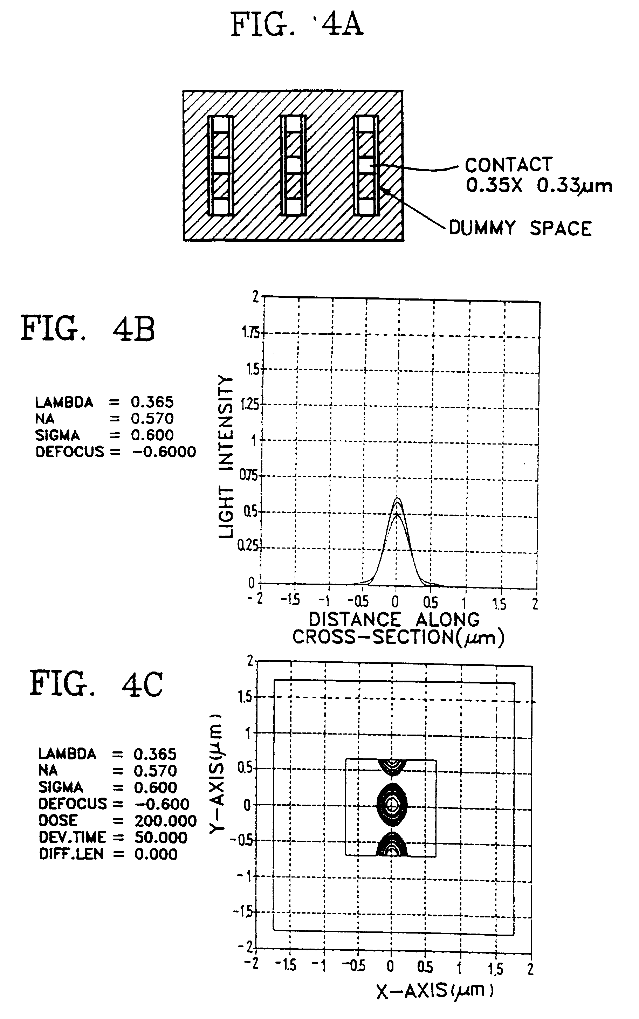

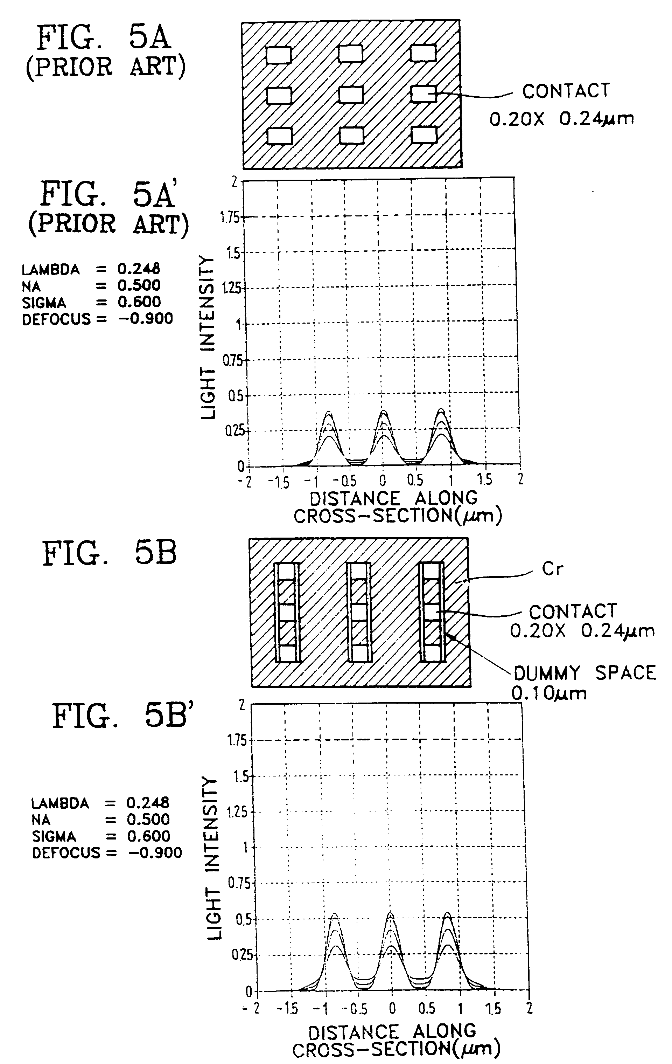

FIGS. 4A-4C and 5A & 5B relate to a first embodiment of the present invention. FIGS. 4A, 4B and 4C are a layout view of patterns, a profile of light intensity, and a photoresist profile, when the i-line mask according to a first embodiment of the present invention is used. A simulation was performed for an i-line (365nm), an NA of 0.57 and a coherency of 0.6. Here, 0.1μm dummy spaces are used, and their size can be optimized in a range of 0.06-0.18μm. In the simulation, a 0.35μm×0.33μm contact hole, smaller than the minimum size resolvable with the i-line, is observed to be opened by the addition of these dummy spaces to the patterns in the mask. The dummy spaces may be formed either in one direction or in a cross pattern with respect to the main pattern. The mask may moreover be of a positive tone or a negative tone. Whether dummy lines or dummy spaces are formed depends on the tone of the mask.

FIGS. 5A & 5A' and 5B & 5B' illustrate, respectively, a conventional deep-ultraviolet mask, a profile of light intensity obtained therewith, a deep-ultraviolet mask according to the first embodiment of the present invention, and a profile of light intensity obtained therewith, respectively. In the result of a simulation in which a 0.2μm×0.24μm contact hole, smaller than the minimum size resolvable with the Deep-ultraviolet (248nm), is simulated, light intensity is increased without a phase shift by formation of 0.1μm-wide dummy spaces in the case of the embodiment of the present invention, thus obtaining the same effect as that of a phase shift mask (see FIG. 5B'). The conditions of the simulation are an NA of 0.5 and a coherency of 0.6.

As described above, according to the first embodiment of the present invention, light intensity is increased by adding dummy spaces to main pattern on the mask, using either a i-line or a Deep-ultraviolet light source, thereby obtaining the same effect as that of a phase shift mask.

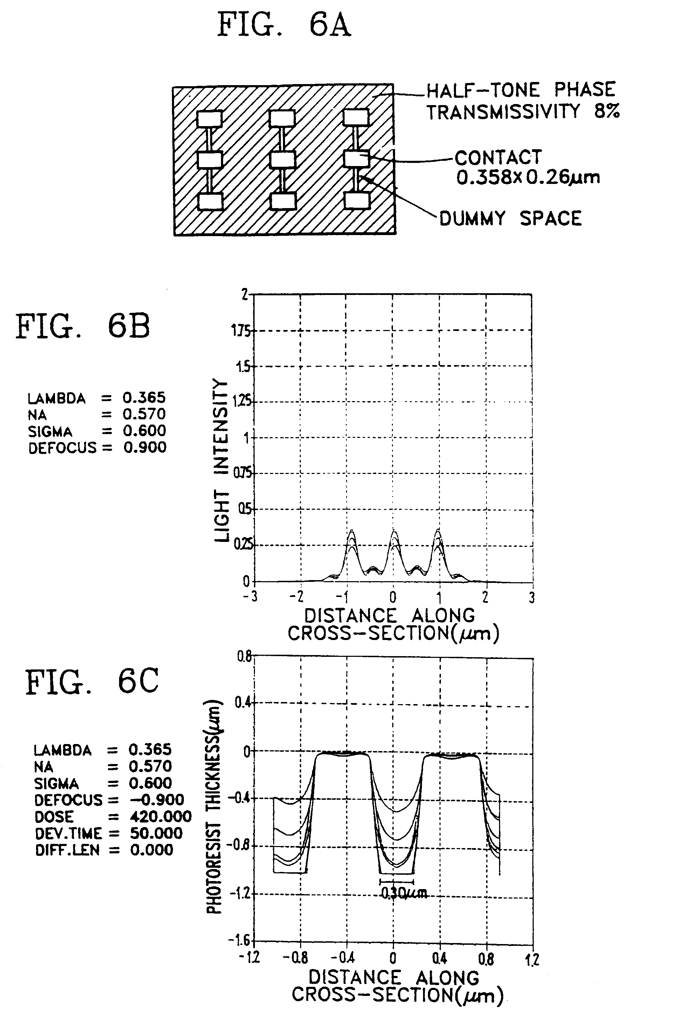

FIGS. 6A, 6B and 6C are, respectively, a layout view of patterns, a profile of light intensity, and a photoresist profile, when a half-tone phase shift mask according to a second embodiment of the present invention is used. In the half-tone phase shift mask, the transmissivity of the light blocking portion is 8% and the phase shift is 180°. A simulation was performed for an i-line (365nm), an NA of 0.57, and a coherency of 0.6. According to the second embodiment of the present invention, light intensity of the half-tone phase shift mask is increased as shown in FIG. 6B, as compared with the light intensity of the conventional half-tone phase shift mask as shown in FIGS. 2A, 2B and 2C, and a 0.38μm×0.26μm contact hole is opened as shown in FIG. 6C by the addition of 0.1μm dummy spaces to the main spaces on the mask. Here, the size of the dummy spaces is preferably determined in a range of 0.05-0.2μm, a size which avoids exposure from a light source. The half-tone phase shift mask may be of a negative tone or a positive tone. The i-line used in the embodiment can be replaced with any light source currently used for lithography including a deep-ultraviolet or argon-fluorin (193nm) light source.

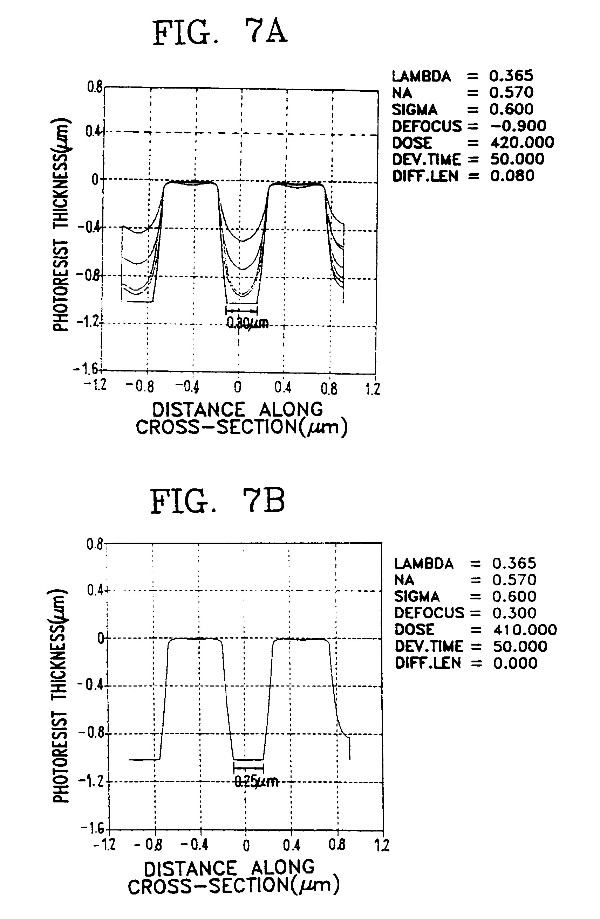

FIGS. 7A and 7B illustrate changes in a contact hole according to the energy of a light source. A 0.25μm contact hole can be opened by adjusting the energy.

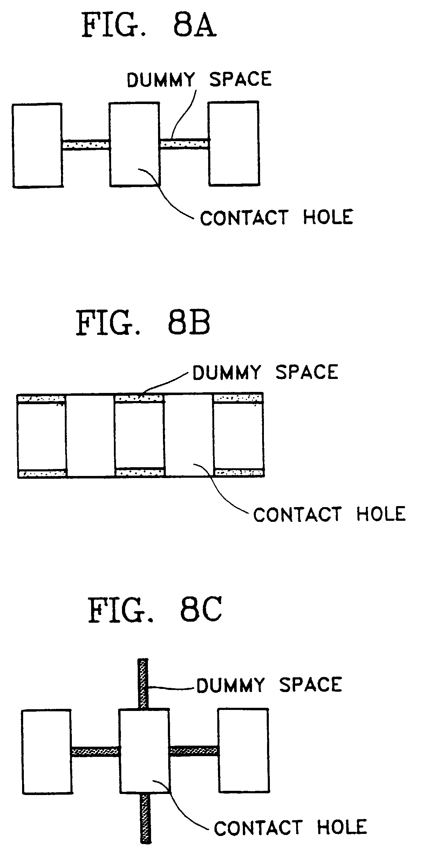

FIGS. 8A, 8B and 8C are views for explaining methods for forming dummy spaces on the half-tone phase shift mask according to the second embodiment of the present invention. The dummy spaces are added to the contact hole at a half height thereof in FIG. 8A, to both edges of the contact hole in FIG. 8B, or to the four sides of the contact hole, thus connecting contact holes, as in FIG. 8C.

As described above, according to the second embodiment of the present invention, in order to obtain a contact hole of a desired size, a side lobe is reduced and the light intensity is increased, by addition of dummy spaces to a pattern of the half-tone phase shift mask such as, for example, a contact hole.

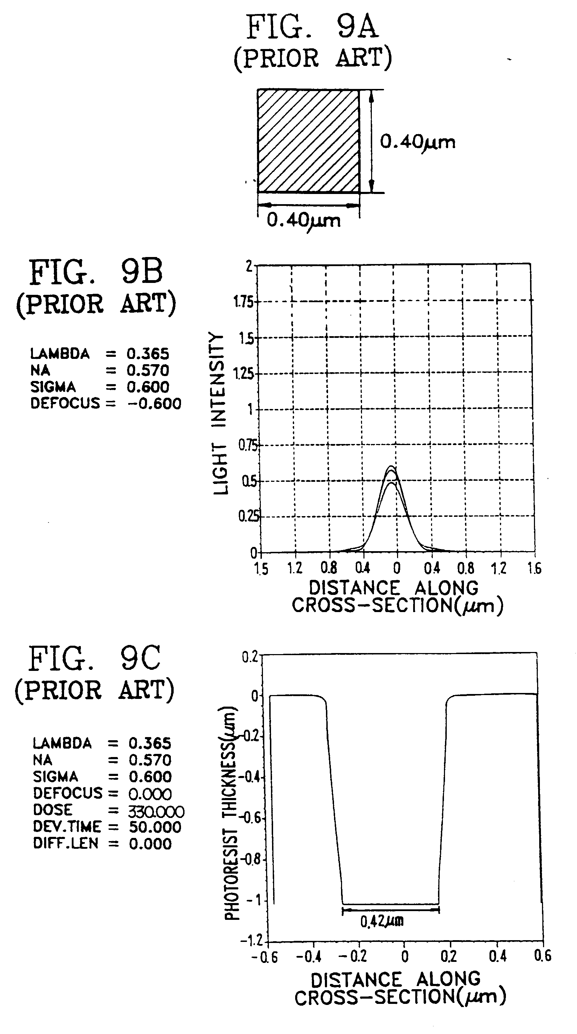

FIGS. 9A-9C through FIGS. 11A-11C are, respectively, pattern layout views, light intensity profiles in aerial images and the final photoresist profiles of, respectively, the conventional mask, the conventional half-tone phase shift mask, and a mask according to a third embodiment of the present invention. Simulations are performed for an i-line (365nm), an NA of 0.57, and a coherency of 0.6.

Referring to FIGS. 9A, 9B and 9C, a 0.36μm photoresist image can be obtained by a 0.4μm×0.4μm contact hole in the layout of the conventional mask.

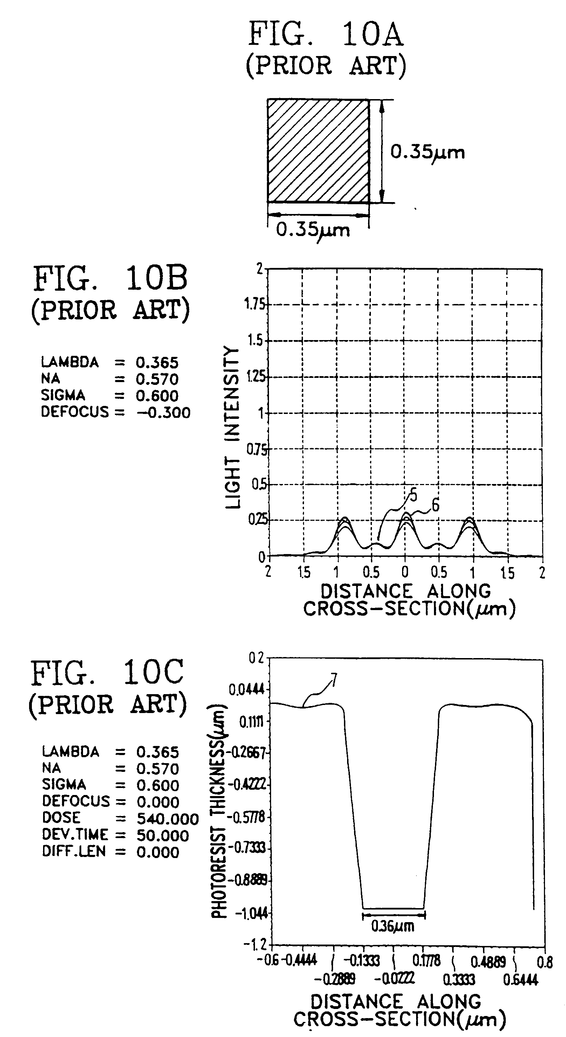

Referring to FIGS. 10A, 10B and 10C, a 0.36μm photoresist image can be obtained by a 0.35μm×0.35μm contact hole in the layout of the conventional half-tone phase shift mask.

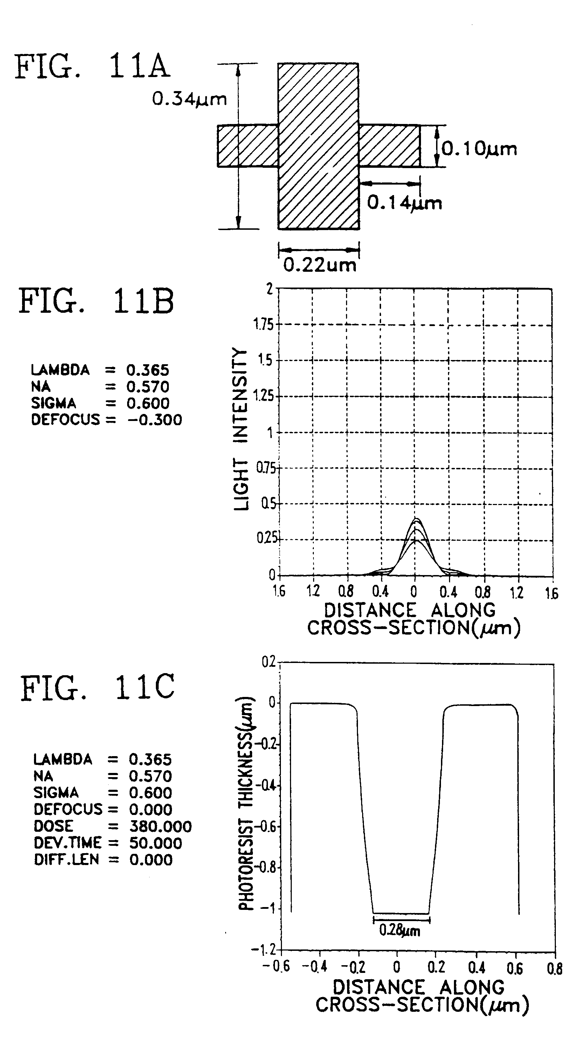

Referring to FIGS. 11A, 11B and 11C, a contact hole of a size up to 0.28μm can be printed on a photoresist by adding 0.1μm×0.14μm dummy spaces too small to be resolved with an i-line (365nm), an NA of 0.57 and a coherency of 0.6, to a 0.34μm×0.22μm rectangular contact hole on the mask.

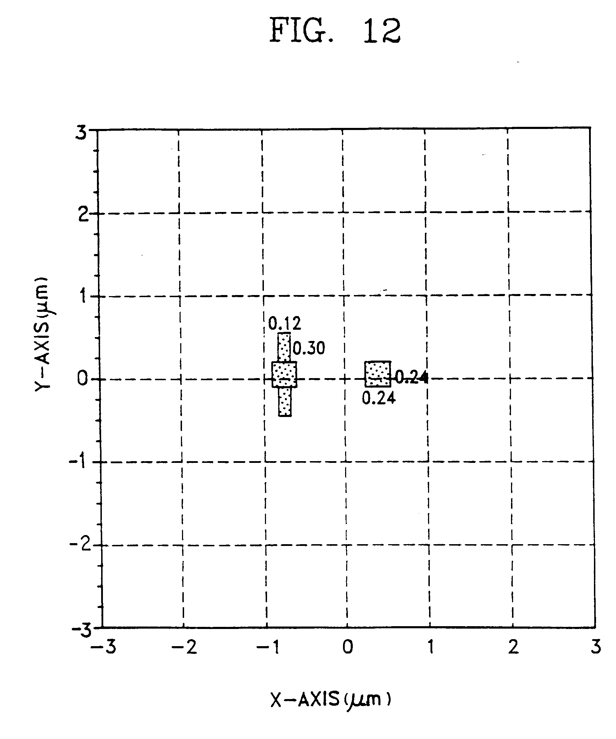

FIGS. 12-15 illustrate the results of simulations of conventional mask patterns and mask patterns according to the third embodiment of the present invention, for an i-line (365nm) and an NA of 0.5.

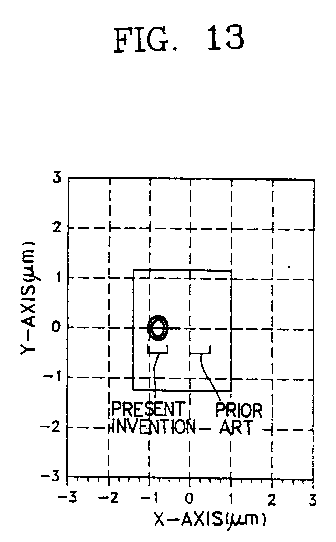

Referring to FIG. 12, the size of pattern of the conventional mask is 0.24μm×0.24μm, and a 0.12μm×0.3μm dummy pattern is added to the upper and lower sides of a pattern in the mask according to the third embodiment. As a result, as shown in FIG. 13, a 0.2μm×0.3μm contact hole is formed with increased exposure in the embodiment of the present invention, while no contact hole is formed with the conventional mask.

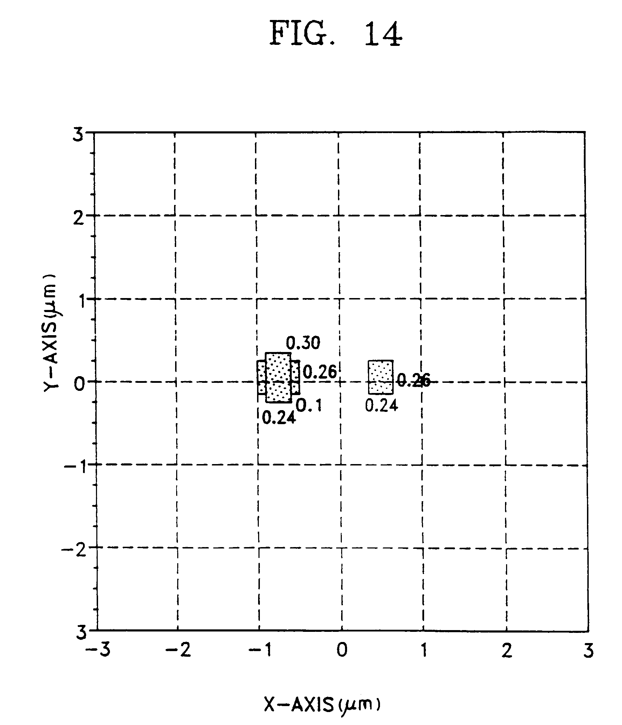

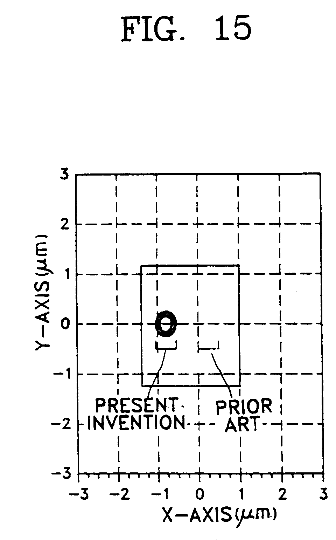

Referring to FIG. 14, a 0.24μm×0.26μm conventional mask pattern is compared with a 0.24μm×0.6μm mask pattern having very small, i.e., 0.1μm-0.26μm, dummy patterns added thereto, in accordance with the third embodiment of the invention. In the embodiment of the present invention, as shown in FIG. 15, a 0.3μm-0.4μm contact hole is obtained while for the conventional mask there is no trace of a contact hole.

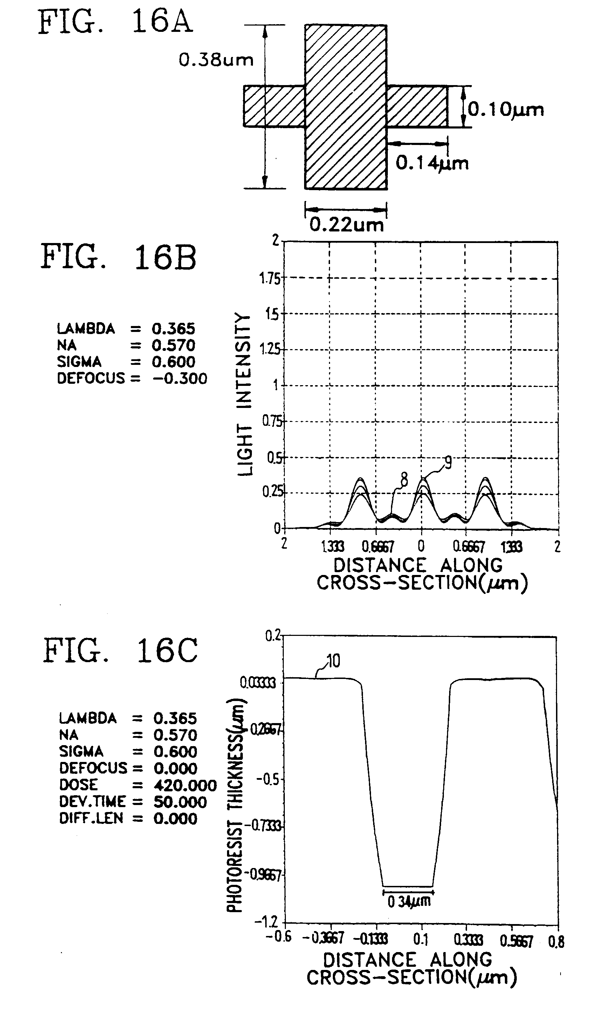

FIGS. 16A, 16B and 16C illustrate, respectively, a layout view of patterns, a profile of light intensity in an aerial image, and a photoresist profile when a mask according to a fourth embodiment of the present invention is used. In the fourth embodiment of the present invention, 0.1μm×0.14μm dummy patterns are added to a 0.22μm×0.38μm rectangular contact pattern on a conventional half-tone phase shift mask. Here, since a high light intensity, denoted by reference numeral 9 of FIG. 16B, is obtained, a contact hole can be formed with a small exposure. In contrast, the conventional half-tone phase shift mask exhibits a low light intensity, denoted by reference numeral 6, in an aerial image, as shown in FIG. 10B, and thus a contact hole can be formed but with an excess exposure. In this case, light intensity "5", corresponding to a side lobe, is increased, resulting in a photoresist recess, such as "7", after development of the photoresist, as is shown in FIG. 10C. However, for the fourth embodiment of the present invention, since a side lobe "8" of the same magnitude (FIG. 16B) as the conventional one does not need an excessive exposure, as is shown in FIG. 16C, scarcely is any photoresist recess 10 created after development of the photoresist.

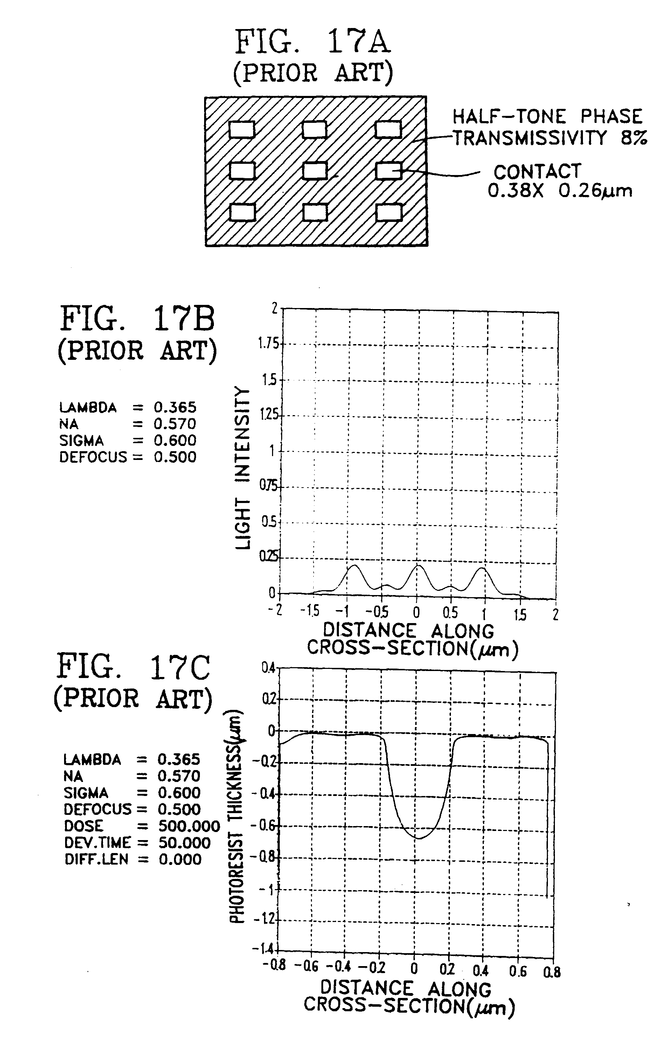

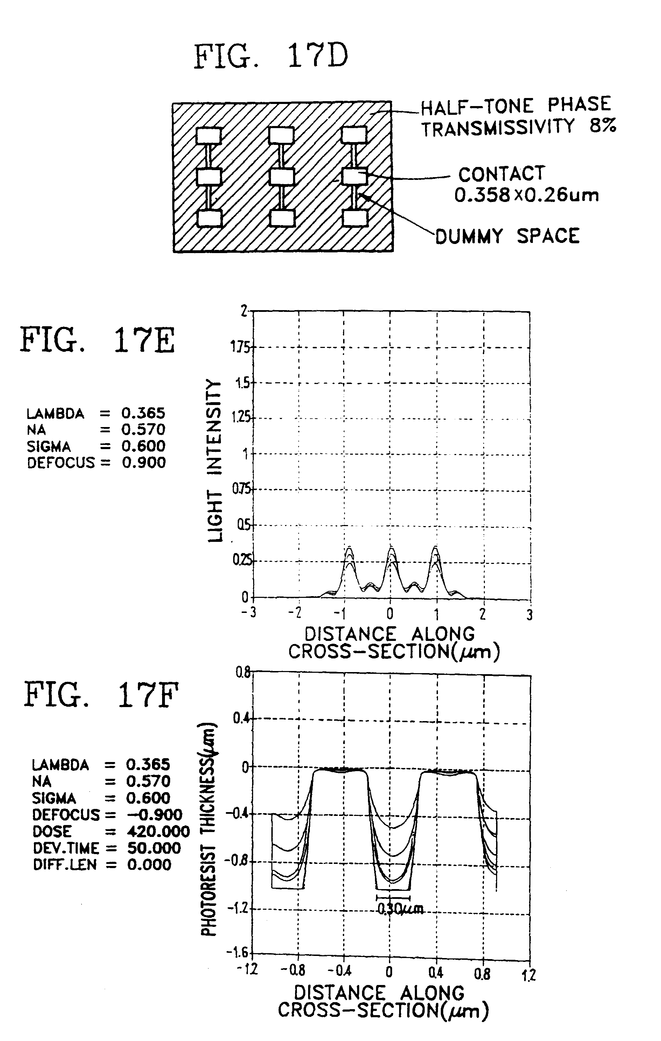

FIGS. 17A-17F illustrate characteristics compared for the conventional half-tone phase shift mask and for a mask according to the second embodiment of the present invention. FIGS. 17A, 17B and 17C show the characteristics of the conventional half-tone phase shift mask, and FIGS. 17D, 17E and 17F show the characteristics of the mask according to the second embodiment of the present invention. Simulations are performed for an i-line and an NA of 0.57. A contact hole is not opened with the conventional half-tone phase shift mask, while a contact hole of a size up to 0.3μm is opened in use of the mask according to the second embodiment.

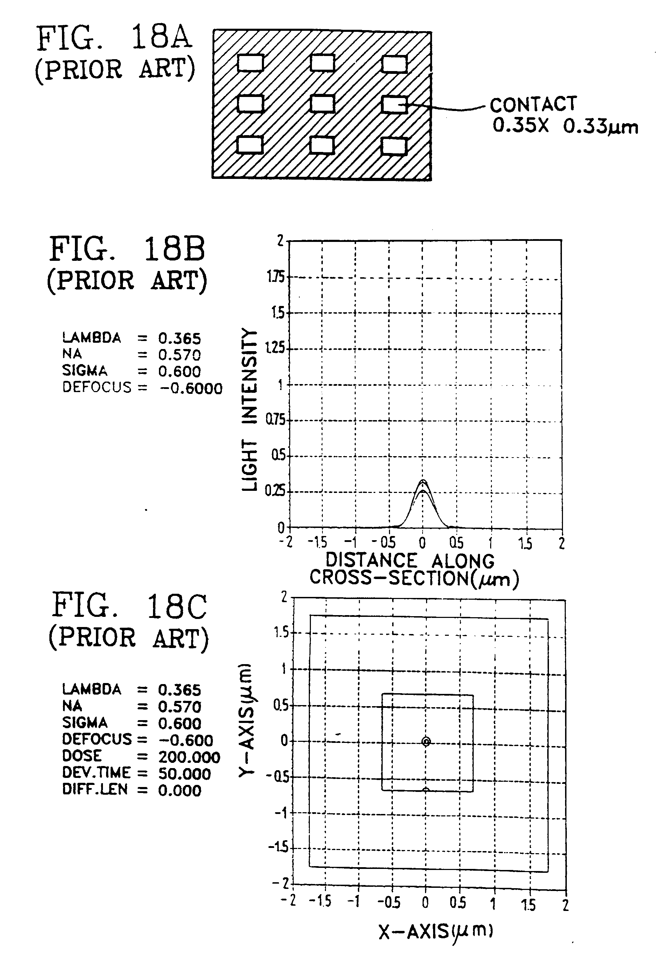

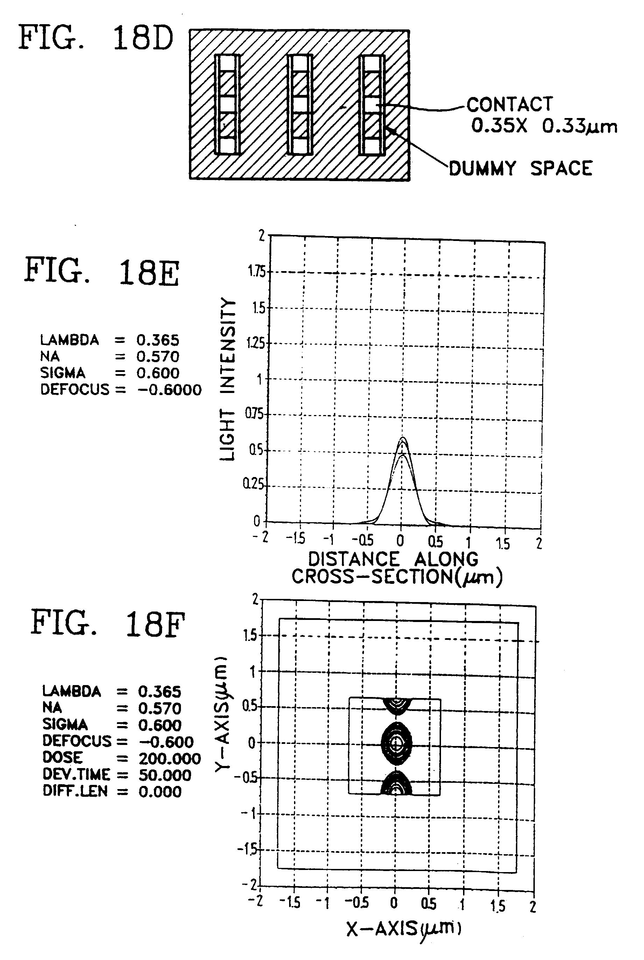

FIGS. 18A-18F illustrate the results of simulations for patterns of a conventional mask and patterns of a mask according to the first embodiment of the present invention, with an i-line (365nm) and an NA of 0.57. FIGS. 18A, 18B and 18C show, respectively, a layout view of patterns, a profile of light intensity in an aerial image, and a photoresist profile, when a conventional mask having a 0.35μm×0.33μm contact hole is used. FIGS. 18D, 18E and 18F show, respectively, a layout view of patterns, a profile of light intensity in an aerial image, and a photoresist profile when a mask of a 0.35μm×0.33μm contact hole having 0.1μm-wide dummy spaces added thereto, according to the first embodiment of the present invention, is used. An aerial image and a photoresist image of excellent characteristics can be obtained reliably with the mask of the first embodiment, in comparison with the conventional mask.

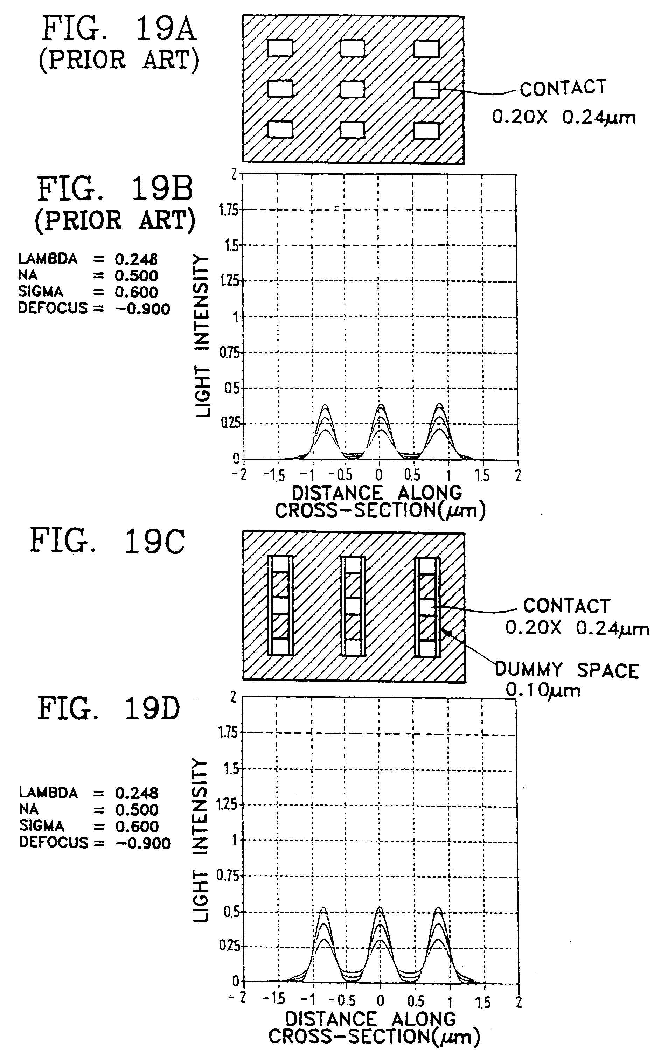

FIGS. 19A & 19B and FIGS. 19C & 19D illustrate the results of simulations of conventional mask patterns and patterns of the mask according to the first embodiment, respectively, for a deep-ultraviolet light (246nm) and an NA value of 0.5. The simulations are intended to allow observation of their effects for a 0.2μm×0.24μm contact hole. The width of dummy spaces in accordance with the first embodiment is 0.1μm. From the comparison of the light intensity profiles shown in FIGS. 19B and 19D, it can be seen that the light intensity in an aerial image of the present invention is much higher than that of the conventional mask.

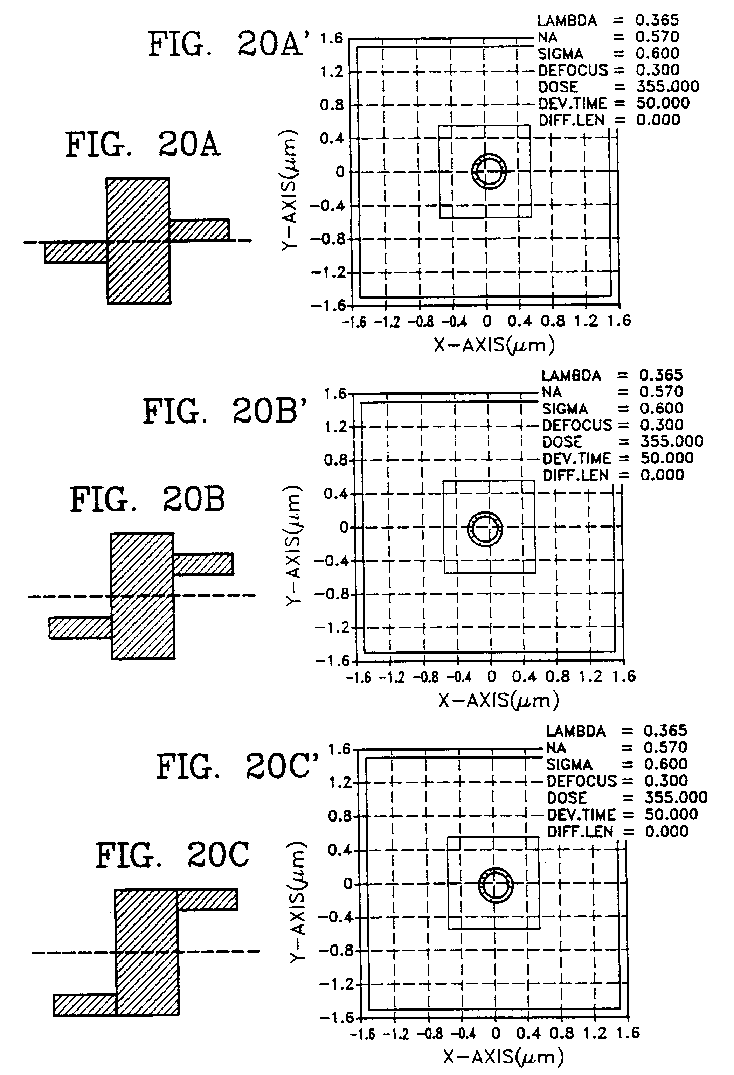

FIGS. 20A-20C and FIGS 20A'-20C' illustrate pattern layouts and photoresist profiles of a mask according to a fifth embodiment of the present invention. In the figures, methods for adding asymmetrically narrow dummy patterns (dummy spaces for a mask of a negative tone and dummy lines for a mask of a positive tone) to a rectangular pattern for a contact hole are shown. As is shown, the degree of distortion of the contact varies with the asymmetrical arrangement of the dummy patterns. However, formation of a small contact hole is still possible. The contact hole can also be formed by adding a dummy pattern inclined with respect to the longitudinal axis of the main pattern, though this is not shown here.

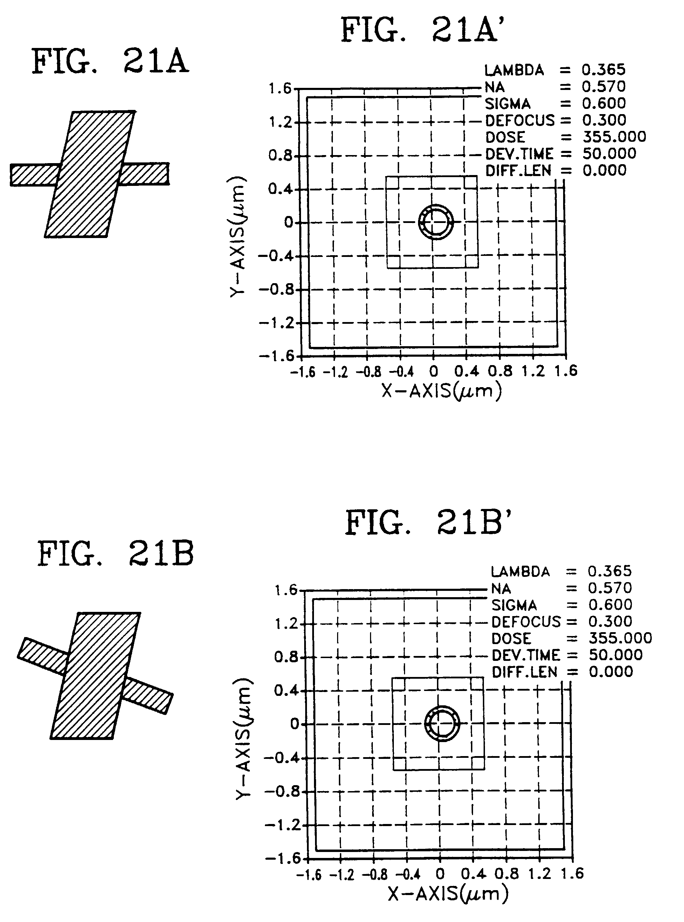

FIGS. 21A & 21B and FIGS. 21A' & 21B' illustrate pattern layouts and photoresist profiles of a mask according to a sixth embodiment of the present invention. Narrow dummy patterns are added to a parallelogram for contact, either in a line or out of line. There is again no problem with formation of a contact hole in this case.

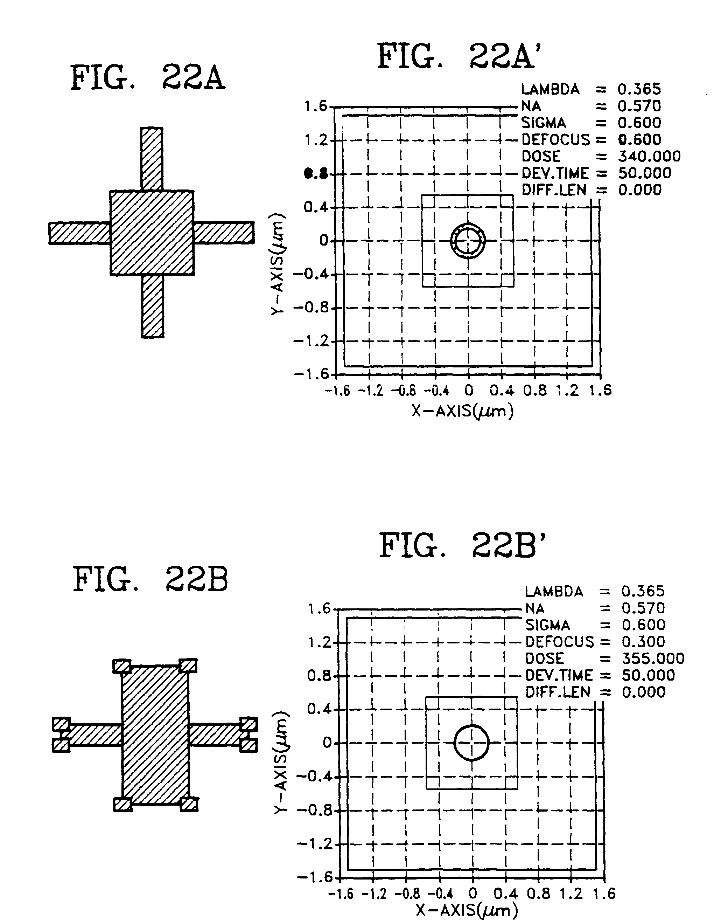

FIGS. 22A & 22B and FIGS. 22A' and 22B' illustrate pattern layouts and photoresist profiles of a mask according to a seventh embodiment of the present invention. As shown in FIG. 22A, dummy patterns are added to a square or rectangular main contact pattern in a cross formation. In the case shown in FIG. 22B, further small dummy patterns are added to the corners of each pattern. An optical proximity effect is improved thereby. It is also possible in these cases to form a small contact hole.

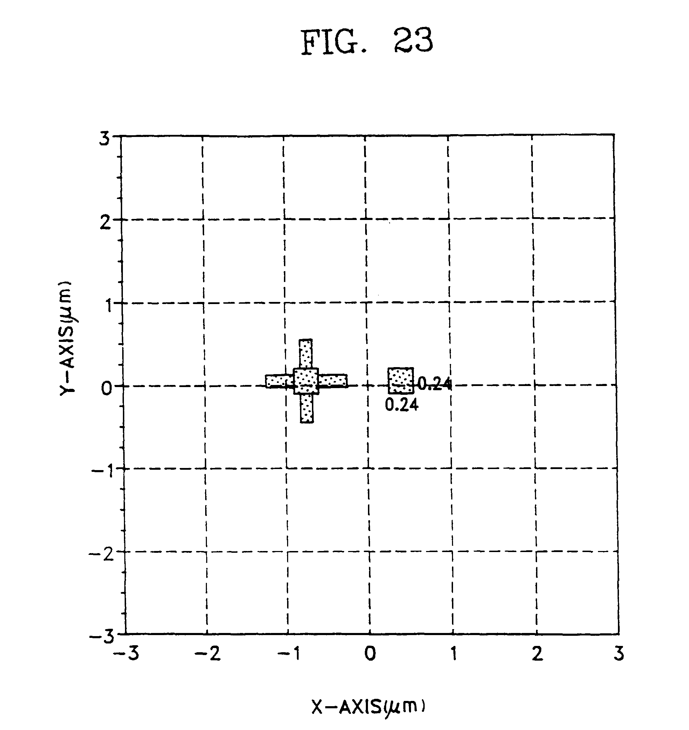

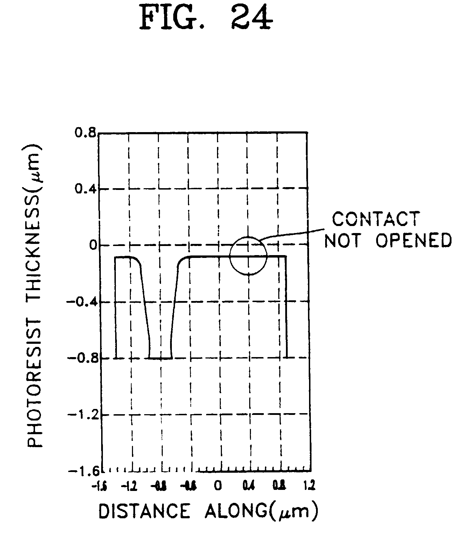

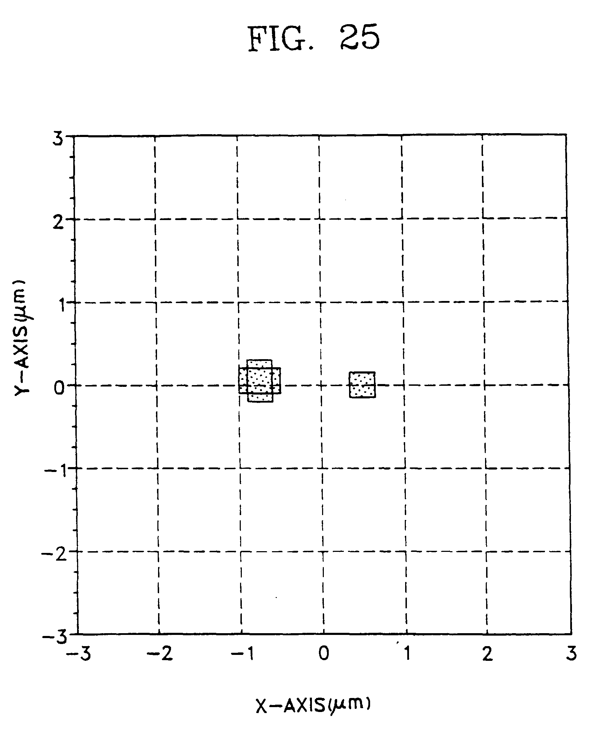

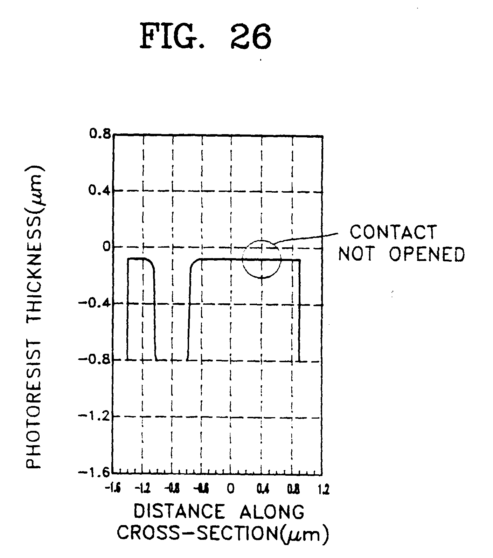

FIGS. 23-26 illustrate the results of simulations of conventional mask patterns and patterns of the mask having dummy patterns of different lengths and widths, according to the seventh embodiment of the present invention. FIGS. 24 and 26 show the results for the photoresist profiles shown in FIGS. 23 and 25. A contact hole is not formed by the conventional mask pattern, as denoted by a dotted line, while a contact hole is formed by the mask pattern of the embodiment of the present invention.

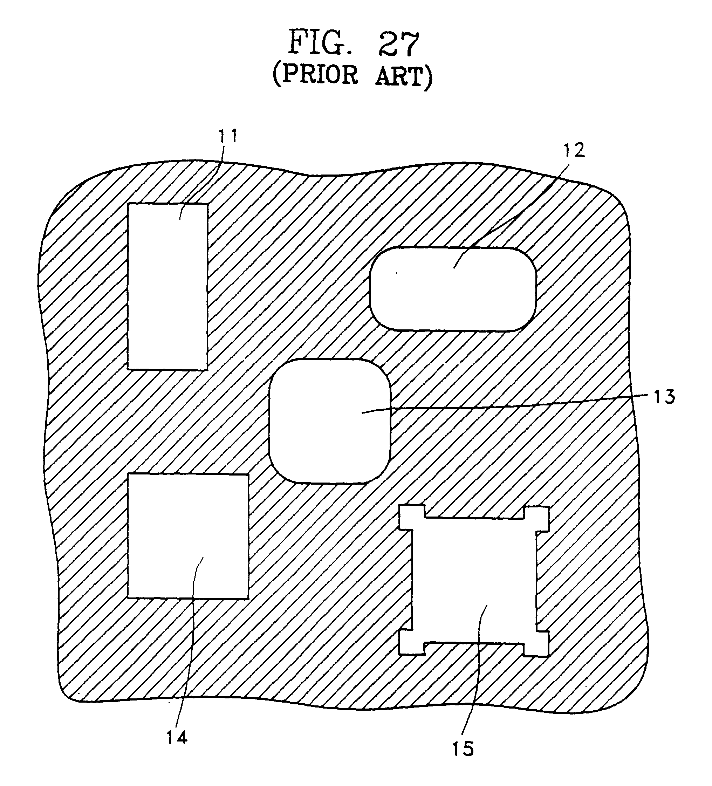

FIG. 27 illustrates conventional mask patterns and layout of mask patterns employed in designing. Reference numerals 11 and 14 denote patterns most widely used in a conventional mask pattern layout. Reference numeral 15 denotes a pattern having serifs added thereto to form a better contact and to have a large process tolerance. Reference numeral 12 denotes an actual shape into which a rectangular pattern in a design is transferred onto a mask by an electron beam or a laser beam. Reference numeral 13 denotes an actual shape into which a square pattern is transferred onto a mask.

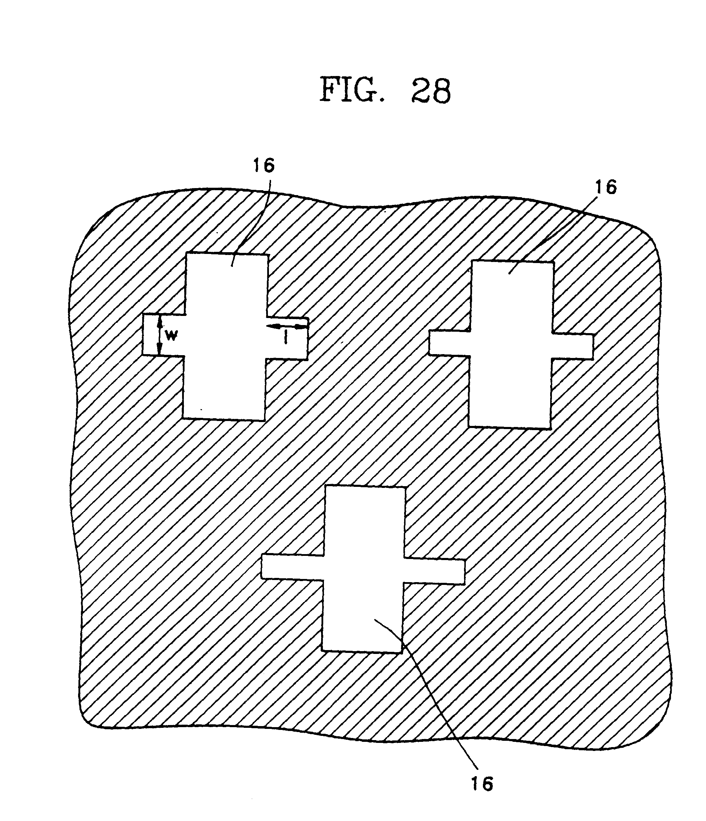

FIGS. 28-31 illustrate mask patterns according to the third through sixth embodiments and layouts of mask patterns employed in designing.

Referring to FIG. 28, each pair of dummy patterns of different length 1 and width w are added to the waist of a main pattern 16, according to the third and fourth embodiments.

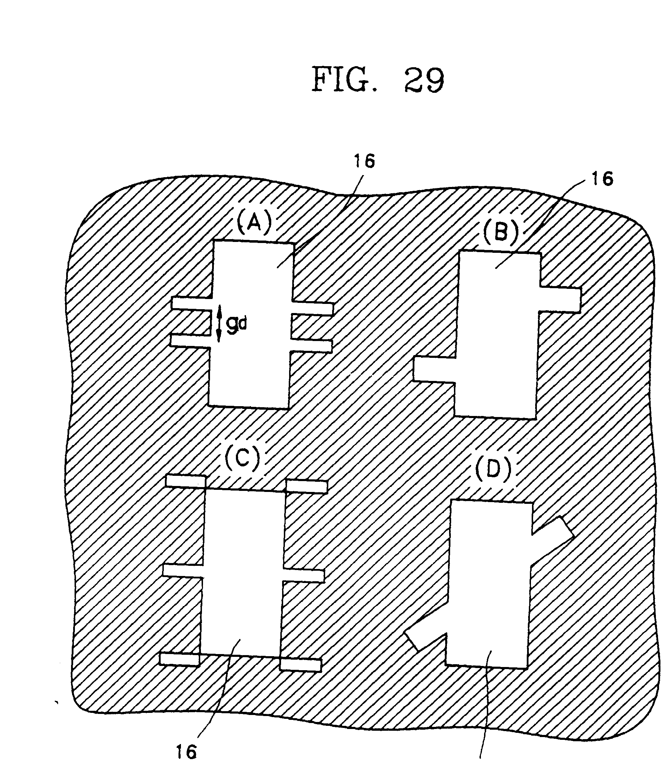

In (A) of FIG. 29 in connection with the fourth and fifth embodiments, two pairs of dummy patterns spaced by a distance gd are added to the middle of main pattern 16. In (B) of FIG. 29, a pair of dummy patterns is added asymmetrically to main pattern 16. In (C) of FIG. 29, at least two pairs of dummy patterns are added to main pattern 16. In (D) of FIG. 29, inclined dummy patterns are added asymmetrically to main pattern 16.

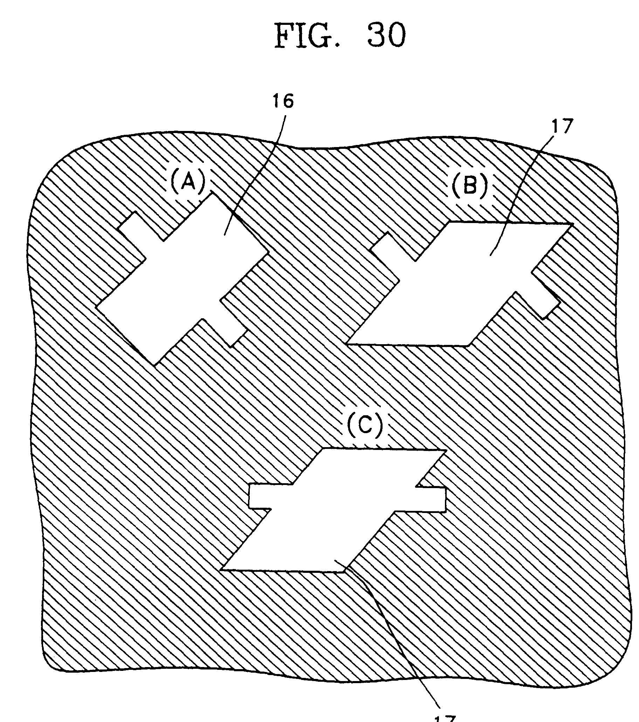

In (A) of FIG. 30 in connection with the fifth and sixth embodiments, main pattern 16 with dummy patterns added thereto is rotated at an angle between 0° and 360° with respect to the longitudinal axis of the main pattern. In (B) and (C) of FIG. 30, a pair of dummy patterns is added to a parallelogram main pattern 17, diagonally, in either an aligned or a misaligned manner. Here, the angles of the parallelogram and the dummy patterns are an angle between 0° and 180° with respect to the longitudinal axis of the main pattern.

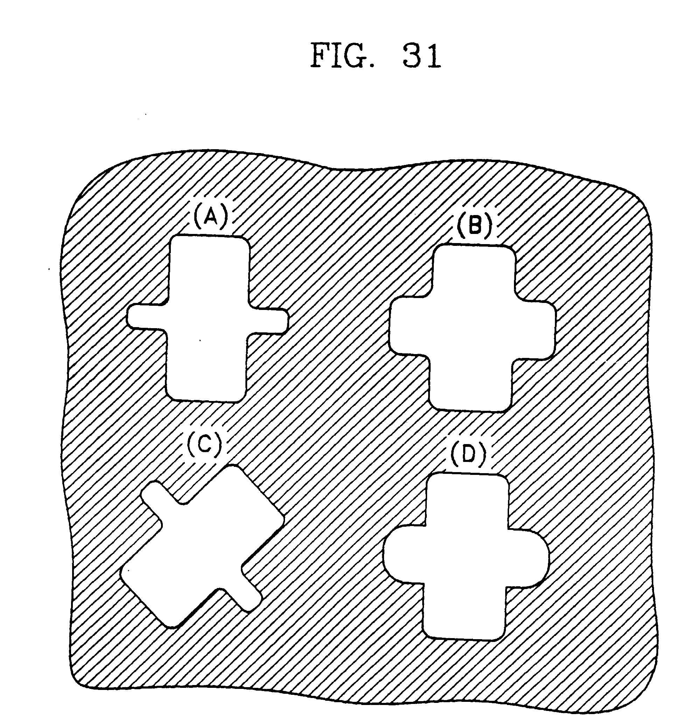

(A)-(D) of FIG. 31 illustrate actual shapes of angular patterns in a design, after formation of mask patterns, for the third through fifth embodiments of the present invention. The corners of a main pattern become less rounded after formation of the actual mask patterns by addition of dummy patterns to the main pattern.

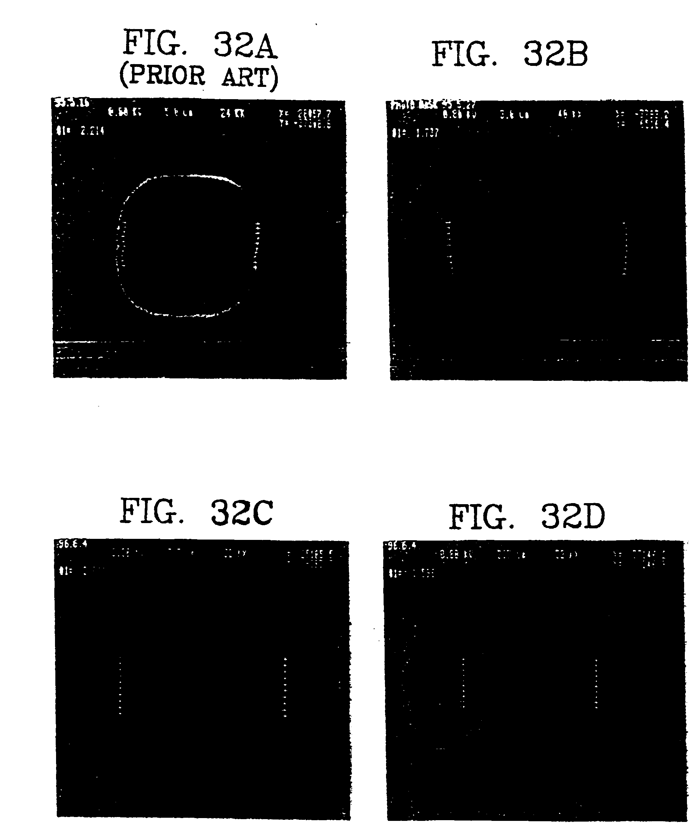

FIGS. 32A and 32B-32D are photographs of actual mask patterns formed both by a conventional method and by methods according to the present invention. FIG. 32A shows an actual mask pattern having rounded corners for a pattern designed to be rectangular. FIGS. 32B, 32C and 32D show actual mask patterns according to embodiments of the present invention. The edges of the patterns are rectangular up to the full configuration of a mask design. In particular, FIGS. 32C and 32D show the configurations of contacts formed with a half-tone phase shift material, e.g., MoSiON. FIGS. 32A and 32B show the configurations of contacts formed with a conventional chromium mask pattern.

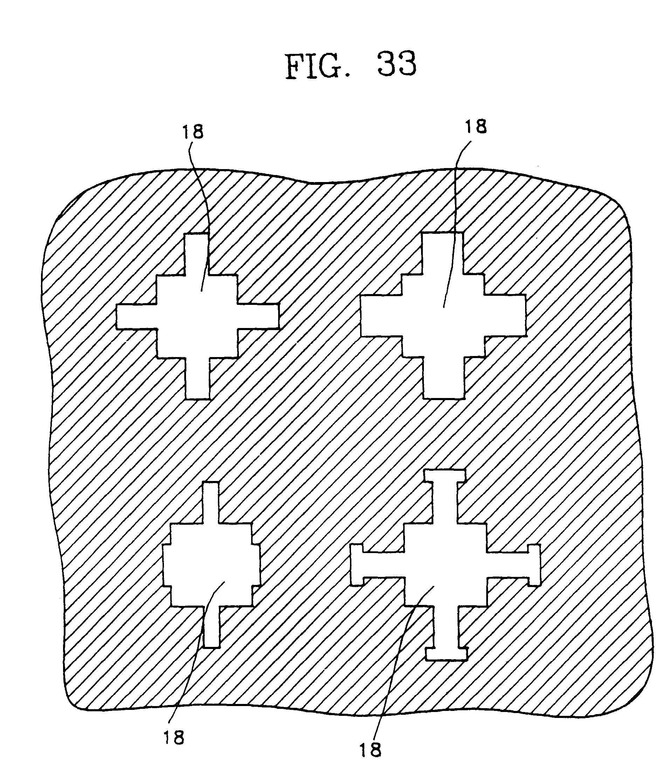

FIGS. 33, 34 and 35 illustrate mask patterns according to the seventh embodiment of the present invention and layouts of mask patterns.

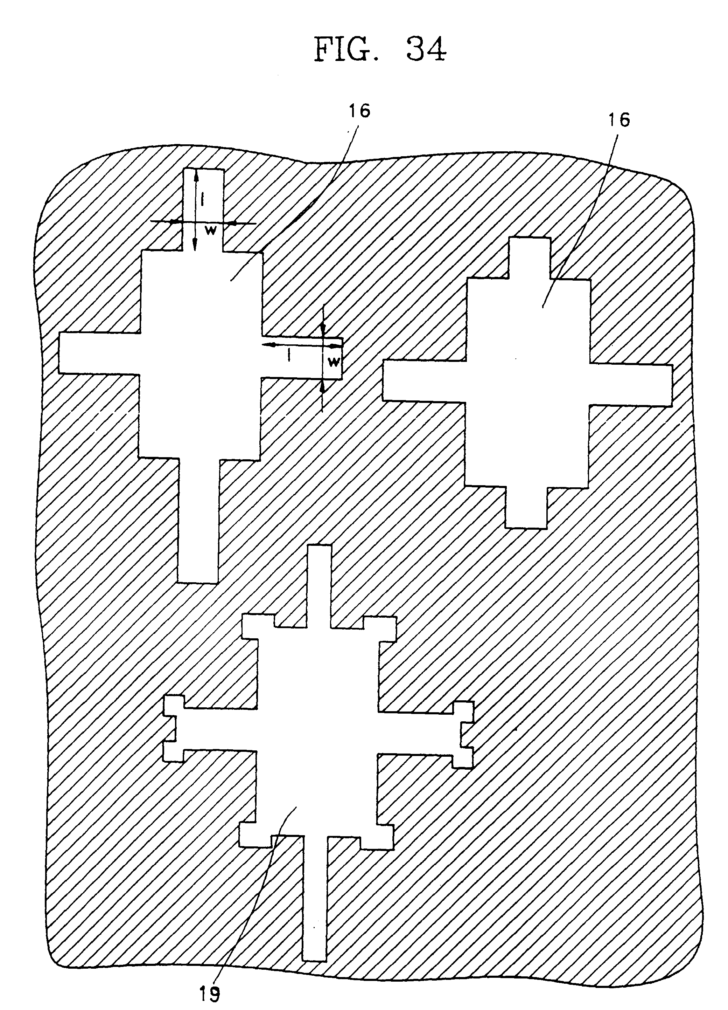

Referring to FIGS. 33 and 34, dummy patterns of different configuration, lengths 1, and widths w are arranged, around in the centre main patterns 16, 18 and 19.

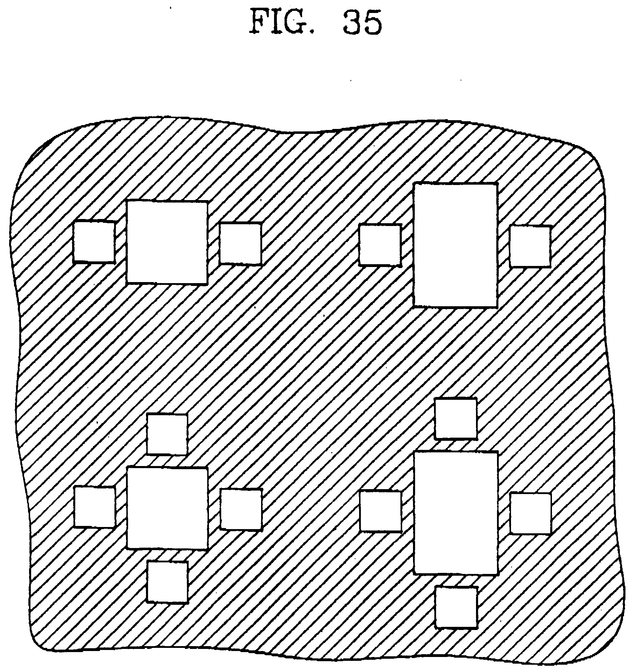

Referring to FIG. 35, it can be seen that such patterns may be formed even by a separate arrangement of the dummy patterns, apart from the main patterns themselves. Even though dummy patterns are arranged apart from main patterns, patterns can be formed.

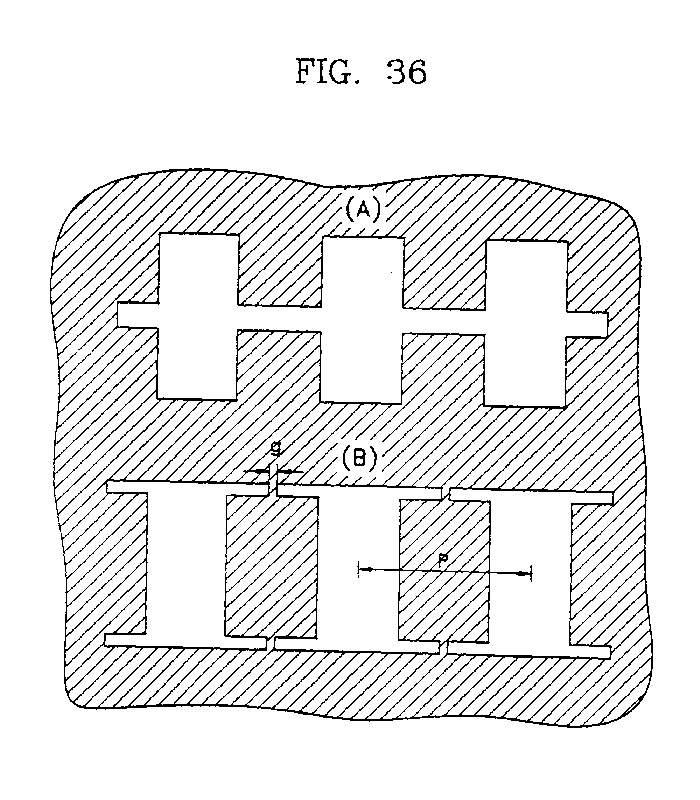

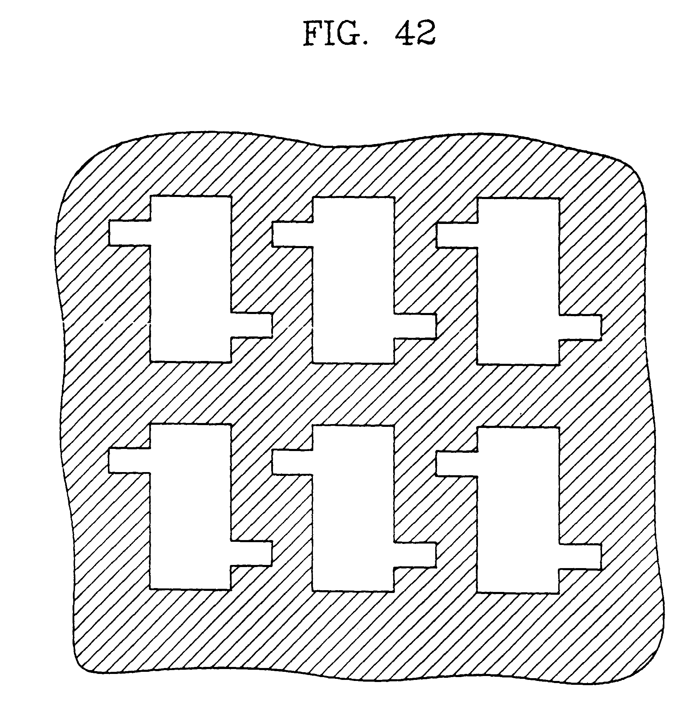

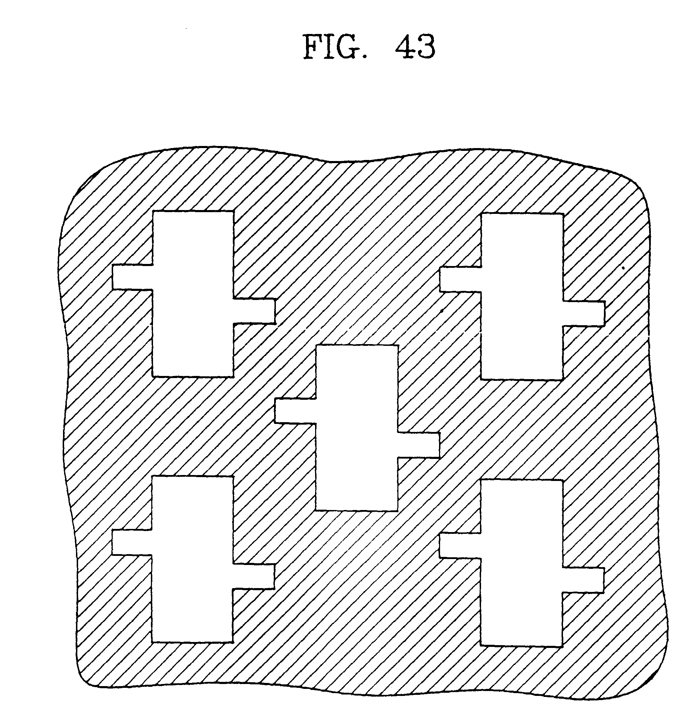

FIGS. 36-44, and FIGS. 45A-45C illustrate mask patterns and layouts of mask patterns, according to the first through seventh embodiments of the present invention.

Referring to (A) and (B) of FIG. 36, to obtain contact holes parallel to one each other according to the first and second embodiments, dummy patterns are arranged to be connected to each other, or patterns of the same configuration can be arranged to be spaced by a distance g. In some cases, when dummy patterns are arranged on the basis of a distance P by which main patterns are spaced, g may be reduced to zero. Since formation of a pattern depends on the wavelength of the light source, the NA value of the exposure device and the process constant $k_1$, as noted in Equation (1), designing a pattern in accordance with these conditions may allow pattern formation when $g \geq 0$.

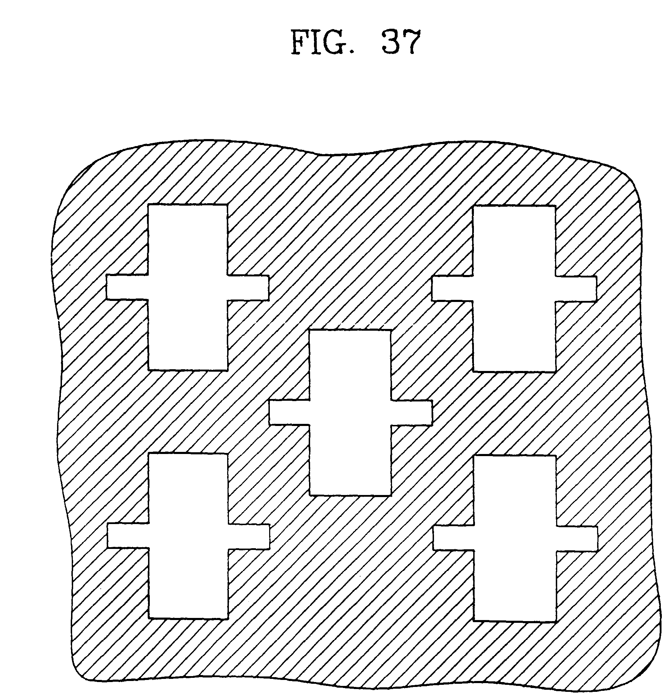

Referring to FIG. 37, patterns of one embodiment in accordance with the third and fourth embodiments of the invention are arranged in a zigzag pattern.

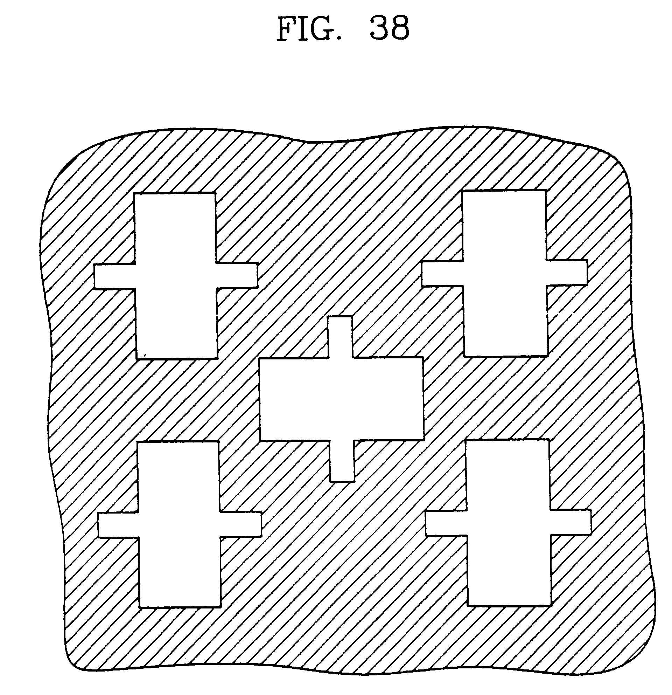

FIG. 38 shows the same layout of patterns as that in FIG. 37 except that one pattern is placed horizontally.

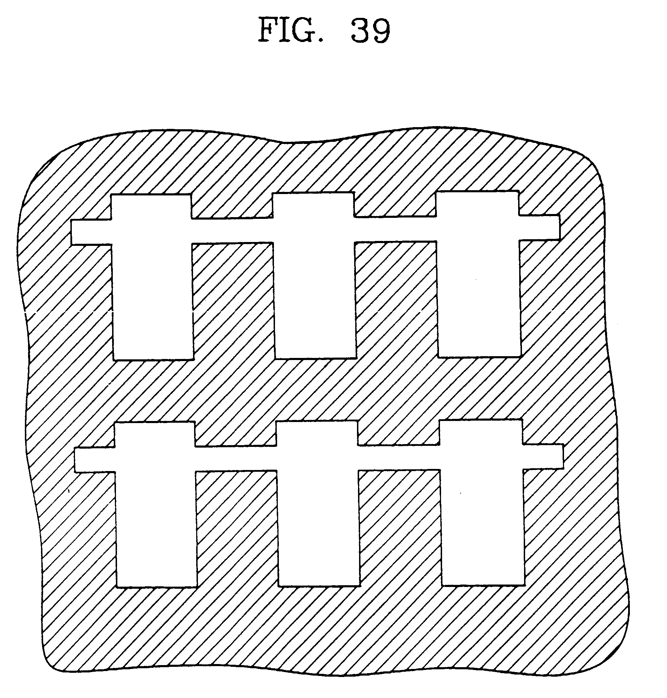

In FIG. 39, dummy patterns are placed in the upper parts of rectangular main patterns, in accordance with the second through fourth embodiments of the invention.

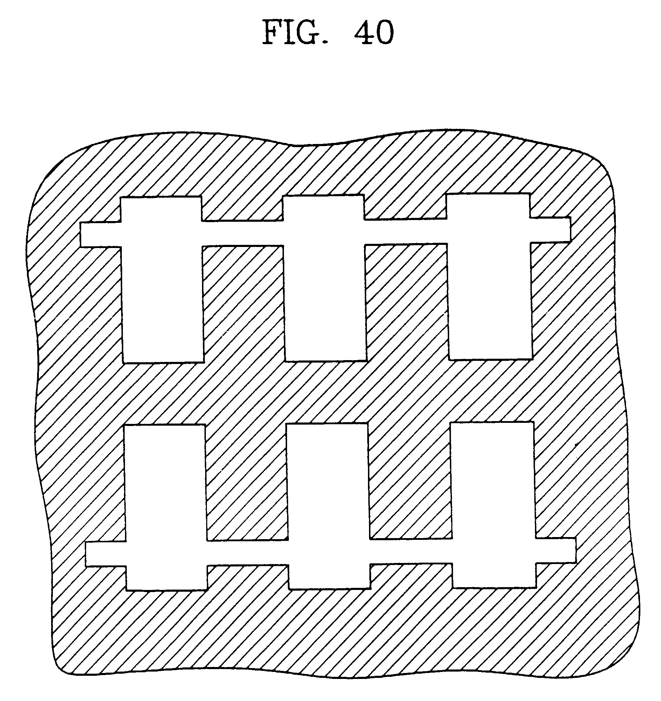

In FIG. 40, dummy patterns are placed in the upper parts of a first group of main patterns and in the lower parts of a second group of main patterns opposite to the first group, in accordance with the second through fourth embodiments of the invention.

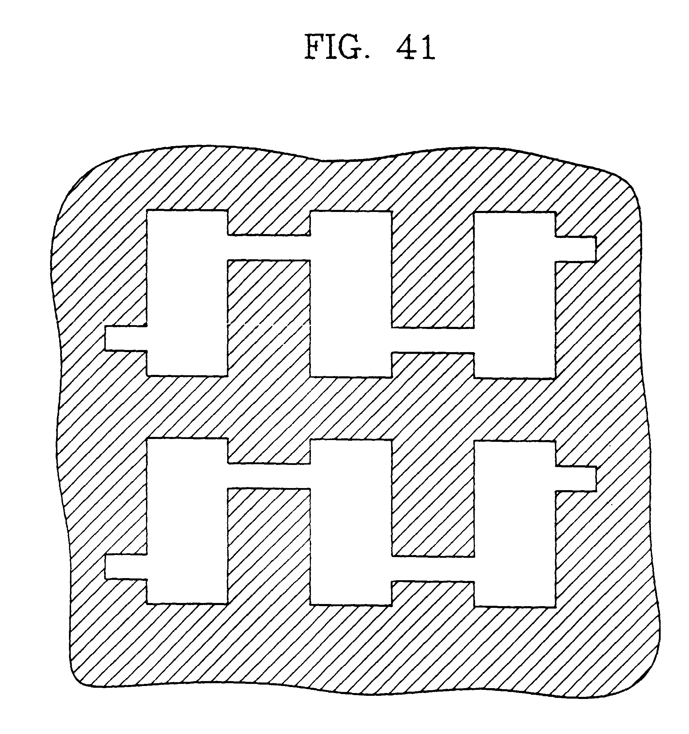

In FIGS. 41 through 43, dummy patterns are arranged asymmetrically with respect to main patterns regularly or continuously, in accordance with the fifth embodiment of the invention.

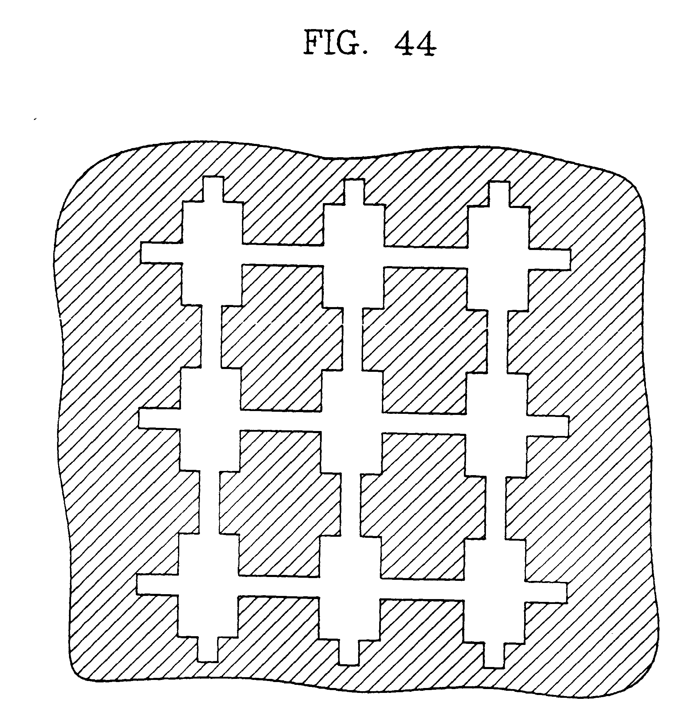

FIG. 44 shows a checkered layout having dummy lines arranged in a cross pattern, in accordance with the seventh embodiment of the invention.

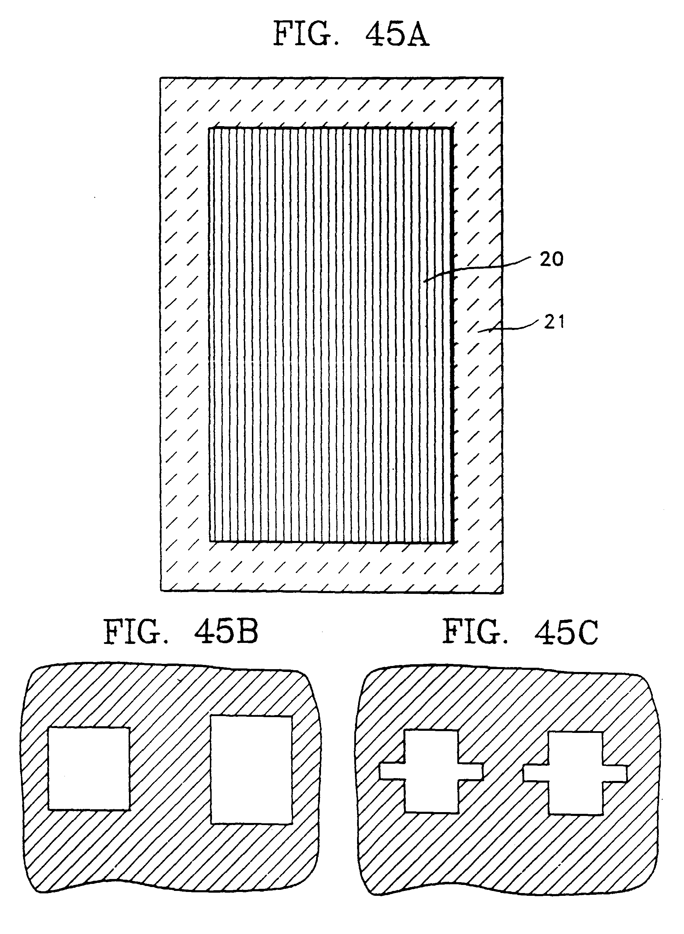

Referring to FIGS. 45A, 45B and 45C, when arranging contact patterns in an actual device, in many cases a cell array area 20 requires relatively small patterns, while a peripheral area 21 requires large contacts. Therefore, a hybrid arrangement is available by arranging the kind of contact patterns or a number of kinds of contact pattern, of the type shown in FIG. 45C in the cell array area, and by arranging rectangular and square patterns as shown in FIG. 45B in the peripheral area.

In the above embodiments, a regular square or a rectangular main pattern, and a dummy pattern at a right angle with respect to the longitudinal axis of the main pattern, are shown. However, it is clear that the present invention can be applied to a case where a main pattern is parallelogram-shaped, and where a dummy pattern is added to the main pattern diagonally with respect to the longitudinal axis of the main pattern.

As described above, according to the present invention, a contact hole as small as is desired can be formed by arranging dummy spaces for a negative-toned mask or dummy lines for a positive-toned mask in a variety of shapes, thus improving an aerial image.

Since finer dummy patterns can be formed with developments in mask fabricating technology, the present invention can be widely applied to 256Mb and 1Gb DRAMs as well as to 64Mb DRAMs, to improve resolution.

The present invention is not restricted to the above embodiments, and it is clearly understood that many variations are possible within the scope of the present invention by those who have ordinary skill in the art.

## Claims

1. A method for forming optically a fine pattern of a semiconductor device, comprising:

   formation of a mask, said mask having a main pattern corresponding to the fine pattern for the semiconductor device, and a dummy pattern associated with the main pattern to improve resolution of the fine pattern; and exposing a semiconductor substrate to a light source through said mask, wherein the dummy pattern of the mask is below the resolution limit of the light source.

2. A mask for use in optical formation of a fine pattern of a semiconductor device, comprising:

   a main pattern corresponding to the fine pattern for the semiconductor device, and a dummy pattern associated with the main pattern to improve resolution of the fine pattern and adapted to be below the resolution limit of a light source for optical formation of the fine pattern.

3. A mask as claimed in claim 2, wherein the size of said dummy pattern is determined according to the size of a desired final fine pattern.

4. A mask as claimed in claim 2 or claim 3, wherein said main pattern and said dummy pattern are of the same tone.

5. A mask as claimed in claim 2 or claim 3, wherein said mask comprises a half-tone phase shift mask.

6. A mask as claimed in any of claims 2 to 5, wherein said dummy pattern is less than or equal to 0.42μm in size, such that when an i-line is used as the light source, exposure by the light source is avoided.

7. A mask as claimed in any of claims 2 to 5, wherein said dummy pattern is less than or equal to 0.3μm in size, such that when deep ultraviolet is used as the light source, exposure by the light source is avoided.

8. A mask as claimed in any of claims 2 to 7, wherein the main pattern of said mask is polygonal.

9. A mask as claimed in any of claims 2 to 8, wherein said dummy pattern is formed in one direction with respect to said main pattern.

10. A mask as claimed in any of claims 2 to 8, wherein said dummy pattern comprises a plurality of patterns formed in a cross pattern.

11. A mask as claimed in any of claims 2 to 8, wherein said dummy pattern comprises at least one pair of dummy patterns.

12. A mask as claimed in claim 11, wherein said pair of dummy patterns are formed symmetrically with respect to said main pattern.

13. A mask as claimed in claim 12, wherein said pair of dummy patterns are arranged in a cross pattern, centering on said main pattern.

14. A mask as claimed in claim 12, wherein each of said pair of dummy patterns is formed substantially midway along the length of said main pattern.

15. A mask as claimed in claim 14, wherein each of said pair of dummy patterns is formed substantially midway along the length of said main pattern to be inclined with respect to the longitudinal axis of said main pattern.

16. A mask as claimed in claim 15, wherein said dummy pattern is inclined at an angle range of 0-180° with respect to the longitudinal axis of said main pattern.

17. A mask as claimed in any of claims 2 to 8, wherein said dummy pattern is formed to connect the sides of said main pattern.

18. A mask as claimed in any of claims 2 to 16, wherein said dummy pattern is formed close to said main pattern or spaced apart from said main pattern by a predetermined distance.

19. A method for forming optically a fine pattern of a semiconductor device, wherein the step of formation of a mask comprises the forming of a mask as claimed in any of claims 2 to 18.

20. A method as claimed in claim 19, wherein the step of formation of a mask comprises the forming of a mask as claimed in claim 8, wherein the fine pattern is formed by using a curved pattern into which said polygonal main pattern is transferred onto said mask.

# FIG. 1A
## (PRIOR ART)

CONTACT
0.35X 0.33µm

# FIG. 1B
## (PRIOR ART)

LAMBDA  = 0.365
NA      = 0.570
SIGMA   = 0.600
DEFOCUS = −0.6000

LIGHT INTENSITY

DISTANCE ALONG
CROSS−SECTION(µm)

# FIG. 1C
## (PRIOR ART)

LAMBDA   = 0.365
NA       = 0.570
SIGMA    = 0.600
DEFOCUS  = −0.600
DOSE     = 200.000
DEV.TIME = 50.000
DIFF.LEN = 0.000

Y−AXIS (µm)

X−AXIS (µm)

## FIG. 2A
## (PRIOR ART)

HALF-TONE PHASE
TRANSMISSIVITY 8%

CONTACT
0.38X 0.26μm

## FIG. 2B
## (PRIOR ART)

LAMBDA = 0.365
NA = 0.570
SIGMA = 0.600
DEFOCUS = 0.500

LIGHT INTENSITY

DISTANCE ALONG
CROSS-SECTION(μm)

## FIG. 2C
## (PRIOR ART)

LAMBDA = 0.365
NA = 0.570
SIGMA = 0.600
DEFOCUS = 0.500
DOSE = 500.000
DEV.TIME = 50.000
DIFF.LEN = 0.000

PHOTORESIST THICKNESS(μm)

DISTANCE ALONG
CROSS-SECTION(μm)

11

# FIG. 3A

# FIG. 3B

# FIG. '4A

CONTACT
0.35X 0.33μm

DUMMY SPACE

# FIG. 4B

LAMBDA  = 0.365
NA      = 0.570
SIGMA   = 0.600
DEFOCUS = −0.6000

LIGHT INTENSITY

DISTANCE ALONG
CROSS−SECTION(μm)

# FIG. 4C

LAMBDA  = 0.365
NA      = 0.570
SIGMA   = 0.600
DEFOCUS = −0.600
DOSE    = 200.000
DEV.TIME = 50.000
DIFF.LEN = 0.000

Y−AXIS(μm)

X−AXIS(μm)

13

FIG. 5A
(PRIOR ART)

CONTACT
0.20X 0.24μm

FIG. 5A'
(PRIOR ART)

LAMBDA = 0.248
NA      = 0.500
SIGMA   = 0.600
DEFOCUS = -0.900

LIGHT INTENSITY

DISTANCE ALONG
CROSS-SECTION(μm)

FIG. 5B

Cr

CONTACT
0.20X 0.24μm

DUMMY SPACE
0.10μm

FIG. 5B'

LAMBDA = 0.248
NA      = 0.500
SIGMA   = 0.600
DEFOCUS = -0.900

LIGHT INTENSITY

DISTANCE ALONG
CROSS-SECTION(μm)

14

## FIG. 6A

HALF-TONE PHASE TRANSMISSIVITY 8%

CONTACT 0.358x0.26μm

DUMMY SPACE

## FIG. 6B

LAMBDA = 0.365
NA = 0.570
SIGMA = 0.600
DEFOCUS = 0.900

LIGHT INTENSITY

DISTANCE ALONG CROSS-SECTION(μm)

## FIG. 6C

LAMBDA = 0.365
NA = 0.570
SIGMA = 0.600
DEFOCUS = −0.900
DOSE = 420.000
DEV.TIME = 50.000
DIFF.LEN = 0.000

PHOTORESIST THICKNESS(μm)

0.30μm

DISTANCE ALONG CROSS-SECTION(μm)

# FIG. 7A

LAMBDA   = 0.365
NA       = 0.570
SIGMA    = 0.600
DEFOCUS  = −0.900
DOSE     = 420.000
DEV.TIME = 50.000
DIFF.LEN = 0.080

# FIG. 7B

LAMBDA   = 0.365
NA       = 0.570
SIGMA    = 0.600
DEFOCUS  = 0.300
DOSE     = 410.000
DEV.TIME = 50.000
DIFF.LEN = 0.000

# FIG. 8A

DUMMY SPACE

CONTACT HOLE

# FIG. 8B

DUMMY SPACE

CONTACT HOLE

# FIG. 8C

DUMMY SPACE

CONTACT HOLE

## FIG. 9A
### (PRIOR ART)

0.40μm

0.40μm

## FIG. 9B
### (PRIOR ART)

LAMBDA  = 0.365
NA      = 0.570
SIGMA   = 0.600
DEFOCUS = −0.600

LIGHT INTENSITY

DISTANCE ALONG
CROSS−SECTION(μm)

## FIG. 9C
### (PRIOR ART)

LAMBDA   = 0.365
NA       = 0.570
SIGMA    = 0.600
DEFOCUS  = 0.000
DOSE     = 330.000
DEV.TIME = 50.000
DIFF.LEN = 0.000

PHOTORESIST THICKNESS(μm)

0.42μm

DISTANCE ALONG
CROSS−SECTION(μm)

18

# FIG. 10A
## (PRIOR ART)

0.35μm

0.35μm

# FIG. 10B
## (PRIOR ART)

LAMBDA  = 0.365
NA      = 0.570
SIGMA   = 0.600
DEFOCUS = −0.300

LIGHT INTENSITY

DISTANCE ALONG
CROSS−SECTION(μm)

# FIG. 10C
## (PRIOR ART)

LAMBDA  = 0.365
NA      = 0.570
SIGMA   = 0.600
DEFOCUS = 0.000
DOSE    = 540.000
DEV.TIME = 50.000
DIFF.LEN = 0.000

PHOTORESIST THICKNESS(μm)

0.36μm

DISTANCE ALONG
CROSS−SECTION(μm)

19

EP 0 770 926 A2

FIG. 11A

0.34μm

0.10μm

0.14μm

0.22um

FIG. 11B

LAMBDA   = 0.365
NA       = 0.570
SIGMA    = 0.600
DEFOCUS = −0.300

DISTANCE ALONG
CROSS−SECTION(μm)

FIG. 11C

LAMBDA   = 0.365
NA       = 0.570
SIGMA    = 0.600
DEFOCUS = 0.000
DOSE     = 380.000
DEV.TIME = 50.000
DIFF.LEN = 0.000

0.28μm

DISTANCE ALONG
CROSS−SECTION(μm)

20

# FIG. 12

# FIG. 13

FIG. 14

# FIG. 15

FIG. 16A

0.38um

0.10μm

0.14μm

0.22um

FIG. 16B

LAMBDA  = 0.365
NA      = 0.570
SIGMA   = 0.600
DEFOCUS = −0.300

LIGHT INTENSITY

9

8

DISTANCE ALONG
CROSS−SECTION(μm)

FIG. 16C

LAMBDA  = 0.365
NA      = 0.570
SIGMA   = 0.600
DEFOCUS = 0.000
DOSE    = 420.000
DEV.TIME = 50.000
DIFF.LEN = 0.000

PHOTORESIST THICKNESS(μm)

10

0 34μm

DISTANCE ALONG
CROSS−SECTION(μm)

# FIG. 17A
## (PRIOR ART)

HALF—TONE PHASE
TRANSMISSIVITY 8%

CONTACT
0.38X 0.26μm

# FIG. 17B
## (PRIOR ART)

LAMBDA = 0.365
NA     = 0.570
SIGMA  = 0.600
DEFOCUS = 0.500

LIGHT INTENSITY

DISTANCE ALONG
CROSS—SECTION(μm)

# FIG. 17C
## (PRIOR ART)

LAMBDA   = 0.365
NA       = 0.570
SIGMA    = 0.600
DEFOCUS  = 0.500
DOSE     = 500.000
DEV.TIME = 50.000
DIFF.LEN = 0.000

PHOTORESIST THICKNESS(μm)

DISTANCE ALONG
CROSS—SECTION(μm)

FIG. 17D

HALF-TONE PHASE
TRANSMISSIVITY 8%

CONTACT
0.358×0.26um

DUMMY SPACE

FIG. 17E

LAMBDA  =  0.365
NA      =  0.570
SIGMA   =  0.600
DEFOCUS =  0.900

LIGHT INTENSITY

DISTANCE ALONG
CROSS-SECTION(μm)

FIG. 17F

LAMBDA   =  0.365
NA       =  0.570
SIGMA    =  0.600
DEFOCUS  = −0.900
DOSE     =  420.000
DEV.TIME =  50.000
DIFF.LEN =  0.000

PHOTORESIST THICKNESS(μm)

0.30μm

DISTANCE ALONG
CROSS-SECTION(μm)

FIG. 18A
(PRIOR ART)

CONTACT
0.35X 0.33μm

FIG. 18B
(PRIOR ART)

LAMBDA = 0.365
NA = 0.570
SIGMA = 0.600
DEFOCUS = −0.6000

LIGHT INTENSITY

DISTANCE ALONG
CROSS−SECTION(μm)

FIG. 18C
(PRIOR ART)

LAMBDA = 0.365
NA = 0.570
SIGMA = 0.600
DEFOCUS = −0.600
DOSE = 200.000
DEV.TIME = 50.000
DIFF.LEN = 0.000

Y−AXIS(μm)

X−AXIS(μm)

FIG. 18D

CONTACT
0.35X 0.33μm

DUMMY SPACE

FIG. 18E

LAMBDA  = 0.365
NA      = 0.570
SIGMA   = 0.600
DEFOCUS = −0.6000

LIGHT INTENSITY

DISTANCE ALONG
CROSS−SECTION(μm)

FIG. 18F

LAMBDA   = 0.365
NA       = 0.570
SIGMA    = 0.600
DEFOCUS  = −0.600
DOSE     = 200.000
DEV.TIME = 50.000
DIFF.LEN = 0.000

Y−AXIS(μm)

X−AXIS(μm)

29

FIG. 19A
(PRIOR ART)

CONTACT
0.20X 0.24μm

FIG. 19B
(PRIOR ART)

LAMBDA  = 0.248
NA      = 0.500
SIGMA   = 0.600
DEFOCUS = −0.900

LIGHT INTENSITY

DISTANCE ALONG
CROSS−SECTION(μm)

FIG. 19C

CONTACT
0.20X 0.24μm

DUMMY SPACE
0.10μm

FIG. 19D

LAMBDA  = 0.248
NA      = 0.500
SIGMA   = 0.600
DEFOCUS = −0.900

LIGHT INTENSITY

DISTANCE ALONG
CROSS−SECTION(μm)

30

FIG. 20A'

FIG. 20A

```
LAMBDA   = 0.365
NA       = 0.570
SIGMA    = 0.600
DEFOCUS  = 0.300
DOSE     = 355.000
DEV.TIME = 50.000
DIFF.LEN = 0.000
```

FIG. 20B'

FIG. 20B

```
LAMBDA   = 0.365
NA       = 0.570
SIGMA    = 0.600
DEFOCUS  = 0.300
DOSE     = 355.000
DEV.TIME = 50.000
DIFF.LEN = 0.000
```

FIG. 20C'

FIG. 20C

```
LAMBDA   = 0.365
NA       = 0.570
SIGMA    = 0.600
DEFOCUS  = 0.300
DOSE     = 355.000
DEV.TIME = 50.000
DIFF.LEN = 0.000
```

# FIG. 21A

# FIG. 21A'

LAMBDA = 0.365
NA = 0.570
SIGMA = 0.600
DEFOCUS = 0.300
DOSE = 355.000
DEV.TIME = 50.000
DIFF.LEN = 0.000

# FIG. 21B

# FIG. 21B'

LAMBDA = 0.365
NA = 0.570
SIGMA = 0.600
DEFOCUS = 0.300
DOSE = 355.000
DEV.TIME = 50.000
DIFF.LEN = 0.000

## FIG. 22A

## FIG. 22A'

```
LAMBDA   = 0.365
NA       = 0.570
SIGMA    = 0.600
DEFOCUS  = 0.600
DOSE     = 340.000
DEV.TIME = 50.000
DIFF.LEN = 0.000
```

## FIG. 22B

## FIG. 22B'

```
LAMBDA   = 0.365
NA       = 0.570
SIGMA    = 0.600
DEFOCUS  = 0.300
DOSE     = 355.000
DEV.TIME = 50.000
DIFF.LEN = 0.000
```

FIG. 23

# FIG. 24

FIG. 25

# FIG. 26

CONTACT
NOT OPENED

# FIG. 27
## (PRIOR ART)

# FIG. 28

# FIG. 29

# FIG. 30

FIG. 31

FIG. 32A
(PRIOR ART)

FIG. 32B

FIG. 32C

FIG. 32D

# FIG. 33

# FIG. 34

## FIG. 35

# FIG. 36

FIG. 37

# FIG. 38

FIG. 39

# FIG. 40

FIG. 41

FIG. 42

FIG. 43

FIG. 44

# FIG. 45A

20

21

# FIG. 45B

# FIG. 45C